# EUROPEAN PATENT APPLICATION

(11) **EP 4 593 068 A2**
(43) Date of publication of application: **30.07.2025**
(21) Application number: 25151980.7
(22) Date of filing: 15.01.2025
(51) Int. Cl.: H01L 21/67

(54) **SUBSTRATE PROCESSING APPARATUS AND SUBSTRATE PROCESSING METHOD**

(30) Priority: 25.01.2024 JP 2024009546
(71) Applicant: SCREEN Holdings Co., Ltd., Kyoto-shi, Kyoto 602-8585 (JP)
(72) Inventor: KAMMURI, Takuya, Kyoto, 602-8585 (JP); NAGAMI, Shuzo, Kyoto, 602-8585 (JP); OKAMOTO, Koichi, Kyoto, 602-8585 (JP); SAWASHIMA, Jun, Kyoto, 602-8585 (JP)
(74) Representative: Kilian Kilian & Partner mbB

(57) **Abstract**

A substrate processing apparatus (100) includes a chamber (11) to accommodate a substrate (W) having a front surface (Wa) on which a device is provided and a rear surface (Wb) positioned on an opposite side to the front surface (Wa), a substrate holding portion (20) to hold the substrate (W) in the chamber (11), a chemical liquid supplying portion (30) to supply a chemical liquid to the front surface (Wa) of the substrate (W) held by the substrate holding portion (20), and a rinse liquid supplying portion (40) to supply a rinse liquid to the front surface (Wa) of the substrate (W) held by the substrate holding portion (20). The substrate processing apparatus (100) includes a cup (80) to trap the rinse liquid scattered from the substrate (W) held by the substrate holding portion (20), a recovered-liquid storage tank (210) to store, as a recovered liquid, the rinse liquid recovered in the cup (80), and a rear surface processing liquid supplying portion (50) to supply the recovered liquid stored in the recovered-liquid storage tank (210) to the rear surface (Wb) of the substrate (W) held by the substrate holding portion (20).

## Description

### CROSS REFERENCE TO RELATED APPLICATIONS

This application claims the benefit of priority to Japanese Patent Application No. 2024-009546 filed on January 25, 2024 and the entire contents of this application are hereby incorporated herein by reference.

### BACKGROUND OF THE INVENTION

### 1. Field of the Invention

The present invention relates to a substrate processing apparatus and a substrate processing method.

### 2. Description of the Related Art

Substrate processing apparatuses that processes substrates have been known. Such a substrate processing apparatus is suitably used for processing a semiconductor substrate. A substrate processing apparatus processes substrates using processing liquids.

Typically, a substrate processing apparatus processes a substrate with a chemical liquid, and then supplies a rinse liquid to the substrate to clean the substrate processed with the chemical liquid. There is a case in which, in a substrate processing apparatus, a chemical liquid and a rinse liquid are supplied not only to a front surface of a substrate but also to a rear surface of the substrate (see Japanese Patent Application Publication No. 2019-125634). In a substrate processing apparatus disclosed in Japanese Patent Application Publication No. 2019-125634, a chemical liquid and a rinse liquid are supplied to a front surface and a rear surface of a substrate and then the substrate is dried, and then infrared rays emitted from a processing liquid adhering to the rear surface of the substrate are transmitted through the substrate and received by a light receiving portion of a detection portion, thereby detecting a liquid residue on the rear surface of the substrate. At this time, the processing liquid scattered from the substrate is trapped in a recovery cup, and the processing liquid trapped in the recovery cup is discharged to the outside of a processing unit from a drain port at a bottom portion of the recovery cup. In the substrate processing apparatus disclosed in Japanese Patent Application Publication No. 2019-125634, in a case where a liquid residue adheres on the rear surface of the substrate, the liquid residue on the rear surface of the substrate is eliminated by performing restorative rinse processing.

### SUMMARY OF THE INVENTION

In recent years, reduction of resources required for substrate processing has been studied for the purpose of reducing the environmental load. However, in the substrate processing apparatus disclosed in Japanese Patent Application Publication No. 2019-125634, in a case where a substrate is processed, there is a possibility that a use amount of a new processing liquid will increase.

A preferred embodiment of the present invention provides a substrate processing apparatus and a substrate processing method capable of reducing a use amount of a new processing liquid.

A substrate processing apparatus according to a preferred embodiment of the present invention includes a chamber to accommodate a substrate having a front surface on which a device is provided and a rear surface positioned on an opposite side to the front surface, a substrate holding portion to hold the substrate in the chamber, a chemical liquid supplying portion to supply a chemical liquid to the front surface of the substrate held by the substrate holding portion, and a rinse liquid supplying portion to supply a rinse liquid to the front surface of the substrate held by the substrate holding portion. Preferably, the substrate processing apparatus includes a cup to trap the rinse liquid scattered from the substrate held by the substrate holding portion, a recovered-liquid storage tank to store, as a recovered liquid, the rinse liquid recovered in the cup, and a rear surface processing liquid supplying portion to supply the recovered liquid stored in the recovered-liquid storage tank to the rear surface of the substrate held by the substrate holding portion.

In one preferred embodiment, the substrate processing apparatus further includes a piping which connects the cup and the recovered-liquid storage tank and into which the rinse liquid trapped in the cup is to flow.

In one preferred embodiment, the rear surface processing liquid supplying portion is to supply the recovered liquid to the rear surface of the substrate in a period in which the rinse liquid supplying portion supplies the rinse liquid to the front surface of the substrate.

In one preferred embodiment, the rear surface processing liquid supplying portion is to supply the rinse liquid to the rear surface of the substrate and then to supply the recovered liquid in the period in which the rinse liquid supplying portion supplies the rinse liquid to the front surface of the substrate.

In one preferred embodiment, while the rinse liquid supplying portion supplies the rinse liquid to the front surface of the substrate, the recovered-liquid storage tank is to recover, as a recovered liquid, the rinse liquid supplied to the substrate. The rear surface processing liquid supplying portion is to supply the recovered liquid to the rear surface of the substrate.

In one preferred embodiment, the rear surface processing liquid supplying portion is to supply the recovered liquid to the rear surface of the substrate both while the chemical liquid supplying portion supplies the chemical liquid to the front surface of the substrate and while the rinse liquid supplying portion supplies the rinse liquid to the front surface of the substrate.

A substrate processing method of a preferred embodiment of the present invention include a step of holding, by a substrate holding portion, a substrate having a front surface on which a device is provided and a rear surface positioned on an opposite side to the front surface, a step of supplying a chemical liquid to the front surface of the substrate held by the substrate holding portion, and a step of supplying a rinse liquid to the front surface of the substrate held by the substrate holding portion after the chemical liquid is supplied to the front surface of the substrate. Preferably, the substrate processing method includes a step of recovering, in a recovered-liquid storage tank, the rinse liquid supplied to the substrate as a recovered liquid, and a step of supplying the recovered liquid in the recovered-liquid storage tank to the rear surface of the substrate held by the substrate holding portion.

The substrate processing method may further include one or arbitrary combination(s) of various features described with respect to the substrate processing apparatus.

The above and yet other objects, features, and effects of the present invention will become more apparent from the following description of the preferred embodiments made with reference to the attached drawings.

### BRIEF DESCRIPTION OF THE DRAWINGS

FIG. 1 is a schematic plan view of a substrate processing apparatus according to a preferred embodiment.
FIG. 2 is a schematic diagram of the substrate processing apparatus according to the preferred embodiment.
FIG. 3 is a block diagram of the substrate processing apparatus according to the preferred embodiment.
FIG. 4 is a flowchart of a substrate processing method according to the preferred embodiment.
FIGS. 5A to 5D are schematic diagrams showing a flow of the substrate processing apparatus according to the preferred embodiment.
FIGS. 6A to 6C are schematic diagrams showing a flow of the substrate processing apparatus according to the preferred embodiment.
FIG. 7 is a schematic diagram of the substrate processing apparatus according to the preferred embodiment.
FIGS. 8A to 8C are schematic diagrams showing a flow of the substrate processing apparatus according to the preferred embodiment.
FIG. 9 is a schematic diagram of the substrate processing apparatus according to the preferred embodiment.
FIGS. 10A to 10C are schematic diagrams showing a flow of the substrate processing apparatus according to the preferred embodiment.
FIGS. 11A to 11C are schematic diagrams showing a flow of the substrate processing apparatus according to the preferred embodiment.
FIG. 12 is a schematic diagram of the substrate processing apparatus according to the preferred embodiment.
FIGS. 13A and 13B are schematic diagrams showing a flow of the substrate processing apparatus according to the preferred embodiment.
FIGS. 14A and 14B are schematic diagrams showing a flow of the substrate processing apparatus according to the preferred embodiment.
FIGS. 15A and 15B are schematic diagrams showing a flow of the substrate processing apparatus according to the preferred embodiment.
FIGS. 16A and 16B are schematic diagrams showing a flow of the substrate processing apparatus according to the preferred embodiment.
FIG. 17 is a schematic diagram of the substrate processing apparatus according to the preferred embodiment.
FIGS. 18A to 18C are schematic diagrams showing a flow of the substrate processing apparatus according to the preferred embodiment.
FIGS. 19A to 19C are schematic diagrams showing a flow of the substrate processing apparatus according to the preferred embodiment.
FIG. 20 is a schematic diagram showing a flow of the substrate processing apparatus according to the preferred embodiment.

### DETAILED DESCRIPTION OF THE PREFERRED EMBODIMENTS

Hereinafter, preferred embodiments of a substrate processing apparatus and a substrate processing method according to the present invention will be described with reference to the drawings. It is noted that, in the drawings, the same reference signs are assigned to the same or corresponding portions, and description shall not be repeated. It is noted that, in the present specification, an X-axis, a Y-axis, and a Z-axis orthogonal to each other may be referred to in order to facilitate understanding of the invention. Typically, the X-axis and the Y-axis are parallel to a horizontal direction, and the Z-axis is parallel to a vertical direction.

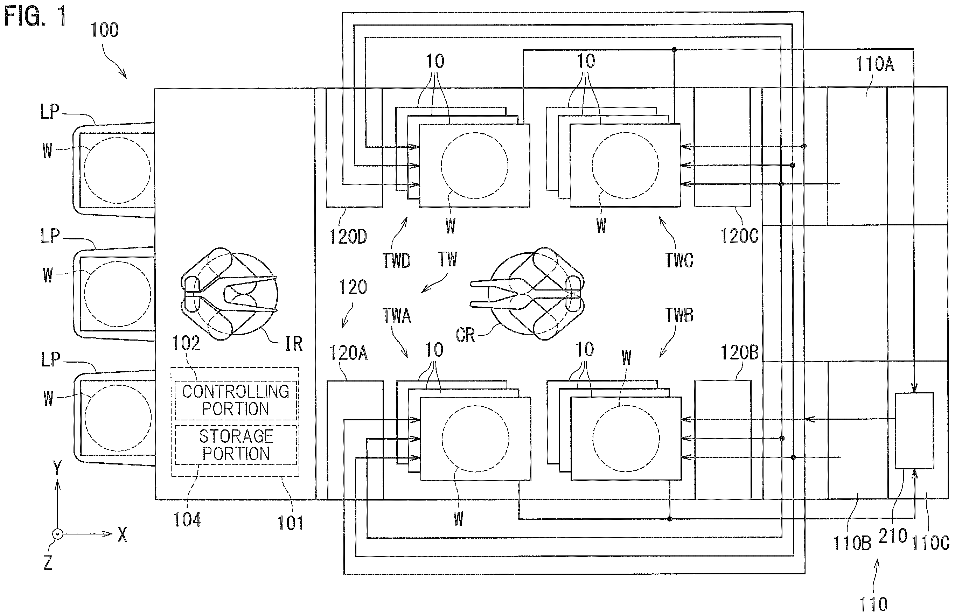

First, a preferred embodiment of a substrate processing apparatus 100 according to a present invention will be described with reference to FIG. 1. FIG. 1 is a schematic plan view of the substrate processing apparatus 100 according to the present preferred embodiment.

The substrate processing apparatus 100 processes a substrate W. The substrate processing apparatus 100 processes the substrate W to perform, on the substrate W, at least one process of etching, surface processing, characteristics imparting, processing film forming, removing at least a part of a film, and cleaning.

The substrate W is used as a semiconductor substrate. The substrate W includes a semiconductor wafer. For example, the substrate W has a substantially disk shape. Here, the substrate processing apparatus 100 processes the substrates W one by one.

As illustrated in FIG. 1, the substrate processing apparatus 100 includes a plurality of substrate processing units 10, a processing liquid cabinet 110, a processing liquid box 120, a plurality of load ports LP, an indexer robot IR, a center robot CR, and a controller 101. The controller 101 controls the load port LP, the indexer robot IR, and the center robot CR. The controller 101 may be configured or programmed to control individual components in the substrate processing unit 10, the processing liquid cabinet 110, and the processing liquid box 120. The controller 101 includes a controlling portion 102 and a storage portion 104.

Each of the load ports LP stacks and accommodates a plurality of substrates W. The indexer robot IR transports the substrates W between the load port LP and the center robot CR. The center robot CR transports the substrates W between the indexer robot IR and the substrate processing unit 10. Each of the substrate processing units 10 discharges a processing liquid onto the substrate W to process the substrate W. The processing liquid contains a chemical liquid, a rinse liquid, a cleaning liquid, a removing liquid, and/or a water repellent. The processing liquid cabinet 110 accommodates the processing liquid. It is noted that, the processing liquid cabinet 110 may accommodate a gas.

Specifically, the plurality of substrate processing units 10 form a plurality of towers TW (four towers TW in FIG. 1) disposed to surround the center robot CR in plan view. Each tower TW includes a plurality of substrate processing units 10 (three substrate processing units 10 in FIG. 1) stacked vertically. The processing liquid boxes 120 correspond to a plurality of towers TW, respectively. A liquid in the processing liquid cabinet 110 is supplied to all of the substrate processing units 10 included in the tower TW corresponding to the processing liquid box 120 through any one of the processing liquid boxes 120. Also, the gas in the processing liquid cabinet 110 is supplied to all of the substrate processing units 10 included in the tower TW corresponding to the processing liquid box 120 through any one of the processing liquid boxes 120.

In the substrate processing apparatus 100, a boundary wall or partition wall is disposed between a region where the center robot CR and the substrate processing units 10 are installed and a region where the processing liquid cabinet 110 is installed.

Typically, the processing liquid cabinet 110 has a storage tank (tank) to prepare the processing liquid. The processing liquid cabinet 110 may have a storage tank for one type of processing liquid or may have a storage tank for a plurality of types of processing liquids. Also, the processing liquid cabinet 110 has a pump to circulate the processing liquid, a valve, a heater, and/or a filter.

The processing liquid cabinet 110 includes a chemical liquid cabinet 110A and a rinse liquid cabinet 110B. For example, the chemical liquid cabinet 110A and the rinse liquid cabinet 110B are disposed apart from each other. It is noted that, the chemical liquid cabinet 110A and the rinse liquid cabinet 110B may be disposed adjacent to each other.

For example, the chemical liquid cabinet 110A supplies the chemical liquid to the processing liquid box 120. Also, the rinse liquid cabinet 110B supplies the rinse liquid to the processing liquid box 120. The processing liquid box 120 supplies the chemical liquid and the rinse liquid to the substrate processing unit 10.

Here, the processing liquid cabinet 110 further includes a recovered-liquid cabinet 110C. The recovered-liquid cabinet 110C stores the recovered liquid obtained by recovering a liquid. For example, the recovered-liquid cabinet 110C recovers, as the recovered liquid, a liquid once used. Also, the recovered-liquid cabinet 110C supplies the recovered liquid obtained by recovering a liquid to the processing liquid box 120.

The recovered-liquid cabinet 110C includes a recovered-liquid storage tank (tank) 210 to store, as the recovered liquid, a liquid once used. The recovered liquid stored in the recovered-liquid storage tank (tank) 210 is supplied to the processing liquid box 120. As described above, the processing liquid cabinet 110 includes the recovered-liquid cabinet 110C.

The processing liquid cabinet 110 may include a recovered-liquid storage tank 210 to store one type of recovered liquid, and may include a recovered-liquid storage tank 210 to store a plurality of types of recovered liquids. Also, the processing liquid cabinet 110 has a pump to circulate the recovered liquid, a valve, a heater, and/or a filter.

The controller 101 controls various operations of the substrate processing apparatus 100. The controller 101 causes the substrate processing unit 10 to process the substrate W.

The controller 101 includes a controlling portion 102 and a storage portion 104. The controlling portion 102 includes a processor. The controlling portion 102 includes, for example, a central processing unit (CPU). Alternatively, the controlling portion 102 may include a general-purpose calculator.

The storage portion 104 is a storage that stores data and a computer program. The data includes recipe data. The recipe data includes information indicating a plurality of recipes. Each of the plurality of recipes defines processing details and a processing procedure of the substrate W.

The storage portion 104 includes a main storage and an auxiliary storage. The main storage is, for example, a semiconductor memory. The auxiliary storage is, for example, a semiconductor memory and/or a hard disk drive. The storage portion 104 may include a removable medium. The controlling portion 102 executes a computer program stored in the storage portion 104 to execute a substrate processing operation.

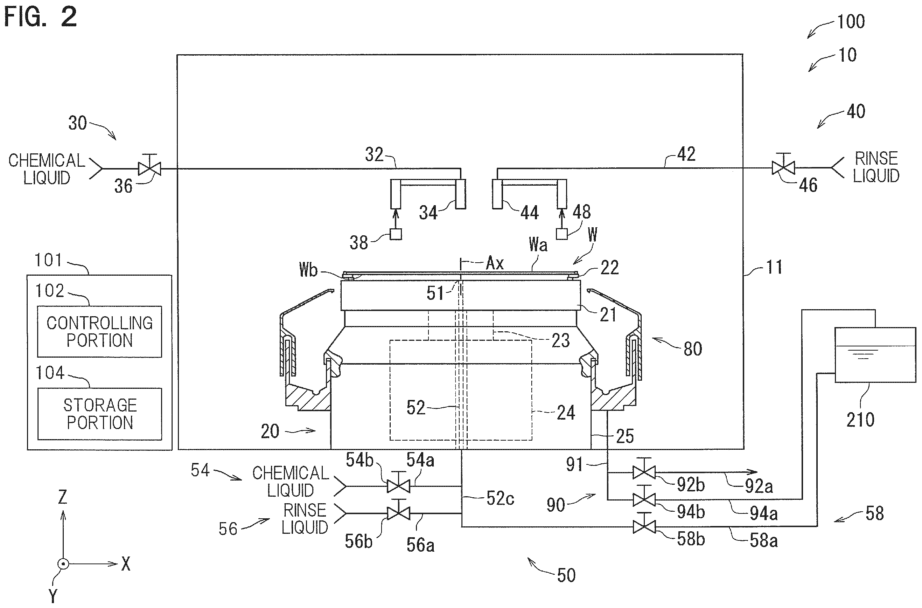

Next, the substrate processing unit 10 in the substrate processing apparatus 100 according to the present preferred embodiment will be described with reference to FIG. 2. FIG. 2 is a schematic diagram of the substrate processing apparatus 100.

The substrate processing apparatus 100 includes the substrate processing unit 10, a chamber 11, a substrate holding portion 20, a chemical liquid supplying portion 30, a rinse liquid supplying portion 40, a rear surface processing liquid supplying portion 50, a cup 80, a drain mechanism 90, and the recovered-liquid storage tank 210.

The chamber 11 has a substantially box shape with an internal space. The chamber 11 accommodates the substrate W. Here, the substrate processing apparatus 100 is a single substrate processing type that processes the substrates W one by one, and the chamber 11 accommodates the substrates W one by one. The substrate W is accommodated in the chamber 11 and processed in the chamber 11. The chamber 11 accommodates at least some of the substrate holding portion 20, the chemical liquid supplying portion 30, the rinse liquid supplying portion 40, the rear surface processing liquid supplying portion 50, and the cup 80.

The substrate holding portion 20 is a substrate holder that holds the substrate W, and may typically be a spin chuck. The substrate W has a front surface Wa and a rear surface Wb. The front surface Wa and the rear surface Wb of the substrate W are principal surfaces of the substrate W, respectively. A device is provided on the front surface Wa of the substrate W. The front surface Wa of the substrate W is a surface on which a device in which an electronic circuit is formed is provided, and the rear surface Wb of the substrate W is a surface on which such a device is not provided. For example, a laminated structure in which a recess is formed is provided on the front surface Wa of the substrate W.

The substrate holding portion 20 horizontally holds the substrate W. The substrate holding portion 20 rotates the substrate W in the state of holding the substrate W. It is noted that, here, the front surface Wa of the substrate W faces vertically upward, and the rear surface Wb of the substrate W faces vertically downward. However, the front surface Wa of the substrate W may face vertically downward, and the rear surface Wb of the substrate W may face vertically upward. As described above, the substrate holding portion 20 horizontally holds the substrate W such that one of the front surface Wa and the rear surface Wb of the substrate W faces upward and the other faces downward.

For example, the substrate holding portion 20 may be a mechanical type or a pinching type that pinches an end portion of the substrate W. The substrate holding portion 20 may have an arbitrary mechanism that holds the substrate W from the rear surface Wb. For example, the substrate holding portion 20 may be a vacuum type. In this case, the substrate holding portion 20 horizontally holds the substrate W by suctioning, on an upper surface, a central portion of the rear surface Wb of the substrate W which is the non-device-forming surface. Alternatively, the substrate holding portion 20 may be a combination of the pinching type and the vacuum type in which a plurality of chuck pins are brought into contact with a circumferential end surface of the substrate W.

For example, the substrate holding portion 20 includes a spin base 21, a chuck member 22, a shaft 23, an electric motor 24, a housing 25, and a nozzle 51. The chuck member 22 is provided on the spin base 21. The chuck member 22 chucks the substrate W. Typically, the spin base 21 includes a plurality of chuck members 22.

The shaft 23 is a hollow shaft. The shaft 23 extends in the vertical direction along a rotation axis Ax. A spin base 21 is coupled to an upper end of the shaft 23. The substrate W is placed above the spin base 21.

The spin base 21 has a disk shape and horizontally supports the substrate W. The shaft 23 extends downward from a central portion of the spin base 21. The electric motor 24 applies a rotation force to the shaft 23. The electric motor 24 rotates the shaft 23 in a rotation direction, thereby rotating the substrate W and the spin base 21 around the rotation axis Ax. The housing 25 surrounds the shaft 23 and the electric motor 24.

The chemical liquid supplying portion 30 supplies a chemical liquid to the substrate W. Typically, the chemical liquid supplying portion 30 supplies the chemical liquid to the front surface Wa of the substrate W. At least a part of the chemical liquid supplying portion 30 is accommodated in the chamber 11.

The chemical liquid contains hydrofluoric acid. For example, hydrofluoric acid may be heated to 40°C or higher and 70°C or lower, or may be heated to 50°C or higher and 60°C or lower. However, hydrofluoric acid may not be heated. Also, the chemical liquid may contain phosphoric acid.

The chemical liquid may contain hydrogen peroxide water. Also, the chemical liquid may contain SC1 (a mixture liquid of ammonia and hydrogen peroxide water), SC2 (a mixture liquid of hydrochloric acid and hydrogen peroxide water), or aqua regia (a mixture of concentrated hydrochloric acid and concentrated nitric acid). Also, the chemical liquid may be diluted with a diluent.

The chemical liquid supplying portion 30 includes a piping 32, a nozzle 34, and a valve 36. The nozzle 34 is connected to the piping 32. The chemical liquid is supplied from a supply source to the piping 32. The valve 36 opens and closes a flow channel in the piping 32. The nozzle 34 discharges the chemical liquid onto the front surface Wa of the substrate W.

The valve 36 adjusts an opening degree of the piping 32 to adjust a flow rate of the chemical liquid flowing in the piping 32. Specifically, the valve 36 includes a valve body (not shown) with a valve seat provided in an interior, a valve element which opens/closes the valve seat, and an actuator (not shown) which moves the valve element between an open position and a closed position.

The nozzle 34 may be configured to be movable with respect to the substrate W. The chemical liquid supplying portion 30 may further include a nozzle moving portion 38. The nozzle moving portion 38 may elevate and lower the nozzle 34, and may horizontally rotate the nozzle 34 around a rotation axis. The nozzle moving portion 38 elevates and lowers the nozzle 34. For example, the nozzle moving portion 38 includes a ball screw mechanism and an electric motor that applies a driving force to the ball screw mechanism. Also, the nozzle moving portion 38 horizontally rotates the nozzle 34. For example, the nozzle moving portion 38 includes an electric motor.

It is noted that, the chemical liquid supplying portion 30 may include the chemical liquid cabinet 110A and the processing liquid box 120 illustrated in FIG. 1.

The rinse liquid supplying portion 40 supplies the rinse liquid to the substrate W. Typically, the rinse liquid is used to clean the substrate W. The rinse liquid supplying portion 40 supplies the rinse liquid to the front surface Wa of the substrate W. At least a part of the rinse liquid supplying portion 40 is accommodated in the chamber 11.

For example, the rinse liquid is used to clean the substrate W processed with the chemical liquid. In one example, the rinse liquid may contain any one of, for example, deionized water (DIW), carbonated water, electrolyzed ion water, ozone water, ammonia water, hydrochloric acid solution with a diluted concentration (for example, about 10 ppm to 100 ppm), and reduced water (hydrogen water).

The rinse liquid supplying portion 40 includes a piping 42, a nozzle 44, and a valve 46. The nozzle 44 is connected to the piping 42. The rinse liquid is supplied from a supply source to the piping 42. The valve 46 opens and closes a flow channel in the piping 42. The nozzle 44 discharges the rinse liquid onto the front surface Wa of the substrate W.

The valve 46 adjusts an opening degree of the piping 42 to adjust a flow rate of the rinse liquid flowing in the piping 42. Specifically, the valve 46 may have a configuration similar to that of the valve 36.

The nozzle 44 may be configured to be movable with respect to the substrate W. The rinse liquid supplying portion 40 may further include a nozzle moving portion 48. The nozzle moving portion 48 may have the same configuration as the nozzle moving portion 38.

It is noted that, the rinse liquid supplying portion 40 may include the rinse liquid cabinet 110B and the processing liquid box 120 illustrated in FIG. 1.

The rear surface processing liquid supplying portion 50 supplies a processing liquid to the rear surface Wb of the substrate W. At least a part of the rear surface processing liquid supplying portion 50 is accommodated in the chamber 11.

For example, the rear surface processing liquid supplying portion 50 supplies the chemical liquid to the rear surface Wb of the substrate W. Typically, while the chemical liquid supplying portion 30 supplies the chemical liquid to the front surface Wa of the substrate W, the rear surface processing liquid supplying portion 50 supplies the chemical liquid to the rear surface Wb of the substrate W. In one example, the rear surface processing liquid supplying portion 50 supplies, to the rear surface Wb of the substrate W, the same type of chemical liquid as the chemical liquid supplied by the chemical liquid supplying portion 30.

Alternatively, the rear surface processing liquid supplying portion 50 supplies the rinse liquid to the substrate W. Typically, while the rinse liquid supplying portion 40 supplies the rinse liquid to the front surface Wa of the substrate W, the rear surface processing liquid supplying portion 50 supplies the rinse liquid to the rear surface Wb of the substrate W. In one example, the rear surface processing liquid supplying portion 50 supplies, to the rear surface Wb of the substrate W, the same type of rinse liquid as the rinse liquid supplied by the rinse liquid supplying portion 40.

It is noted that, the rear surface processing liquid supplying portion 50 may supply a chemical liquid (diluted chemical liquid) diluted with a diluent to the rear surface Wb of the substrate W. Typically, while the chemical liquid supplying portion 30 supplies the diluted chemical liquid to the front surface Wa of the substrate W, the rear surface processing liquid supplying portion 50 may supply the diluted chemical liquid to the rear surface Wb of the substrate W.

In the present preferred embodiment, the rear surface processing liquid supplying portion 50 supplies the recovered liquid to the rear surface Wb of the substrate W. Typically, the recovered liquid is a liquid obtained by recovering a processing liquid that has been used once. In one example, the recovered liquid is a liquid obtained by recovering a rinse liquid that has been used once. For example, the rinse liquid used for rinse processing of the substrate W is recovered and used as the recovered liquid.

Typically, the substrate W is used for a microfabricated semiconductor device. Therefore, the chemical liquid or the rinse liquid supplied from the supply source is an unused new liquid, and the chemical liquid or the rinse liquid supplied from the supply source has a low impurity concentration. On the other hand, the recovered liquid may have a slightly higher impurity concentration as compared to the chemical liquid or the rinse liquid supplied from the supply source. Consequently, it is possible to prevent particles produced by cleaning the rear surface Wb of the substrate W or processing the front surface Wa of the substrate W with a chemical liquid, etc., from adhering to the rear surface Wb of the substrate W. However, it is preferable that the impurity concentration of the recovered liquid also be low.

For example, while the rinse liquid supplying portion 40 supplies the rinse liquid to the front surface Wa of the substrate W, the rear surface processing liquid supplying portion 50 may supply the recovered liquid to the rear surface Wb of the substrate W. Alternatively, while the chemical liquid supplying portion 30 supplies the chemical liquid to the front surface Wa of the substrate W, the rear surface processing liquid supplying portion 50 may supply the recovered liquid to the rear surface Wb of the substrate W. Alternatively, while the chemical liquid supplying portion 30 supplies the diluted chemical liquid diluted with the diluent to the front surface Wa of the substrate W, the rear surface processing liquid supplying portion 50 may supply the chemical liquid diluted with the recovered liquid to the rear surface Wb of the substrate W.

The rear surface processing liquid supplying portion 50 includes a nozzle 51, a piping 52, a piping 52c, a chemical liquid supplying portion 54, a rinse liquid supplying portion 56, and a recovered-liquid supplying portion 58. The piping 52 is positioned in the chamber 11. The piping 52 penetrates the center of the shaft 23 in the vertical direction. The nozzle 51 is disposed at an end portion of the piping 52. The nozzle 51 is positioned opposing the center of the rear surface Wb of the substrate W. The piping 52 is connected to the piping 52c outside the chamber 11. The processing liquid supplied to the rear surface Wb of the substrate W flows into the piping 52c and the piping 52. The processing liquid which has flowed through the piping 52c and the piping 52 is discharged from the nozzle 51 to the rear surface Wb of the substrate W.

The chemical liquid supplying portion 54 supplies the chemical liquid to the rear surface Wb of the substrate W. Specifically, the chemical liquid supplying portion 54 supplies the chemical liquid to the rear surface Wb of the substrate W through the piping 52c and the piping 52.

The chemical liquid supplying portion 54 includes a piping 54a and a valve 54b. The chemical liquid is supplied from the supply source to the piping 54a. The valve 54b opens and closes a flow channel in the piping 54a. The valve 54b adjusts an opening degree of the piping 54a to adjust a flow rate of the chemical liquid flowing in the piping 54a. Specifically, the valve 54b includes a valve body (not shown) with a valve seat provided in an interior, a valve element which opens/closes the valve seat, and an actuator (not shown) which moves the valve element between an open position and a closed position.

The chemical liquid which has flowed through the piping 52c and the piping 52 from the piping 54a is discharged from the nozzle 51 to the rear surface Wb of the substrate W.

The rinse liquid supplying portion 56 supplies the rinse liquid to the rear surface Wb of the substrate W. Specifically, the rinse liquid supplying portion 56 supplies the rinse liquid to the rear surface Wb of the substrate W through the piping 52c and the piping 52.

The rinse liquid supplying portion 56 includes a piping 56a and a valve 56b. The rinse liquid is supplied from the supply source to the piping 56a. The valve 56b opens and closes a flow channel in the piping 56a. The valve 56b adjusts an opening degree of the piping 56a to adjust a flow rate of the rinse liquid flowing in the piping 56a. The valve 56b may have a configuration similar to that of the valve 54b.

The rinse liquid which has flowed through the piping 52c and the piping 52 from the piping 56a is discharged from the nozzle 51 to the rear surface Wb of the substrate W.

The recovered-liquid supplying portion 58 supplies the recovered liquid to the rear surface Wb of the substrate W. Specifically, the recovered-liquid supplying portion 58 supplies the recovered liquid to the rear surface Wb of the substrate W through the piping 52c and the piping 52.

The recovered-liquid supplying portion 58 includes a piping 58a and a valve 58b. The recovered liquid is supplied to the piping 58a from the recovered-liquid storage tank 210 serving as a supply source. The valve 58b opens and closes a flow channel in the piping 58a. The valve 58b adjusts an opening degree of the piping 58a to adjust a flow rate of the recovered liquid flowing in the piping 58a. The valve 58b may have a configuration similar to that of the valve 54b.

The recovered liquid which has flowed through the piping 52c and the piping 52 from the piping 58a is discharged from the nozzle 51 to the rear surface Wb of the substrate W.

The cup 80 is elevated and lowered along the vertical direction. The cup 80 is elevated to an upper position that is positioned laterally to the substrate W. Also, the cup 80 is lowered to a lower position that is positioned obliquely below the substrate W. In FIG. 2, the cup 80 is positioned at the lower position. In a case where any one of the chemical liquid, the rinse liquid, and the recovered liquid is supplied to the substrate W, the cup 80 is elevated until the cup 80 is positioned laterally to the substrate W.

The cup 80 traps the processing liquid scattering around the substrate W by the rotation of the substrate W. For example, when the chemical liquid supplying portion 30 supplies the chemical liquid to the rotating substrate W, the chemical liquid scatters laterally from the substrate W. In this case, the cup 80 traps, at the upper position, the chemical liquid scattering laterally from the substrate W. Also, in a case where the rinse liquid supplying portion 40 supplies the rinse liquid to the rotating substrate W, the cup 80 traps, at the upper position, the rinse liquid scattering laterally from the substrate W. Similarly, in a case where the rear surface processing liquid supplying portion 50 supplies the processing liquid to the rotating substrate W, the cup 80 traps, at the upper position, the processing liquid scattering laterally from the substrate W.

As described above, while any one of the chemical liquid supplying portion 30, the rinse liquid supplying portion 40, and the rear surface processing liquid supplying portion 50 supplies any one of the chemical liquid, the rinse liquid, and the processing liquid to the substrate W, the cup 80 traps, at the upper position, any one of the chemical liquid, the rinse liquid, and the processing liquid scattering laterally from the substrate W. Also, when a period in which any one of the chemical liquid supplying portion 30, the rinse liquid supplying portion 40, and the rear surface processing liquid supplying portion 50 supplies any one of the chemical liquid, the rinse liquid, and the processing liquid to the substrate W ends, the cup 80 is lowered to the lower position that is positioned obliquely below the substrate W.

Specifically, when the chemical liquid supplying portion 30 and/or the chemical liquid supplying portion 54 supplies the chemical liquid to the substrate W while the substrate holding portion 20 holds and rotates the substrate W, the chemical liquid supplied to the substrate W scatters around the substrate W by the rotation of the substrate W. The cup 80 is positioned at the upper position that covers a side portion of the substrate W when the chemical liquid supplying portion 30 and/or the chemical liquid supplying portion 54 supplies the chemical liquid to the substrate W, and the cup 80 traps the chemical liquid scattering around the substrate W by the rotation of the substrate W. Similarly, when the rinse liquid supplying portion 40 and/or the rinse liquid supplying portion 56 supplies the rinse liquid to the substrate W while the substrate holding portion 20 holds and rotates the substrate W, the rinse liquid supplied to the substrate W scatters around the substrate W by the rotation of the substrate W. The cup 80 is positioned at the upper position that covers the side portion of the substrate W when the rinse liquid supplying portion 40 and/or the rinse liquid supplying portion 56 supplies the rinse liquid to the substrate W, and the cup 80 traps the rinse liquid scattering around the substrate W by the rotation of the substrate W.

Further, when the recovered-liquid supplying portion 58 supplies the recovered liquid to the substrate W while the substrate holding portion 20 holds and rotates the substrate W, the recovered liquid supplied to the substrate W scatters around the substrate W by the rotation of the substrate W. The cup 80 is positioned at the upper position that covers the side portion of the substrate W when the recovered-liquid supplying portion 58 supplies the recovered liquid to the substrate W, and the cup 80 traps the recovered liquid scattering around the substrate W by the rotation of the substrate W. As described above, the cup 80 traps any one of the chemical liquid, the rinse liquid, and the recovered liquid scattering around the substrate W by the rotation of the substrate W.

The drain mechanism 90 discharges the chemical liquid, the rinse liquid, and/or the recovered liquid trapped in the cup 80. A piping is connected to the cup 80, and the chemical liquid, the rinse liquid, and/or the recovered liquid trapped in the cup 80 flows through the piping and is discharged to the outside.

The drain mechanism 90 is connected to the recovered-liquid storage tank 210. The drain mechanism 90 causes at least a part of the chemical liquid, the rinse liquid, and/or the recovered liquid trapped in the cup 80 to flow in the recovered-liquid storage tank 210 and be stored in the recovered-liquid storage tank 210 as a recovered liquid.

The recovered-liquid storage tank 210 may selectively recover the chemical liquid, the rinse liquid, and/or the recovered liquid trapped in the cup 80. For example, the recovered-liquid storage tank 210 recovers the rinse liquid and/or the recovered liquid trapped in the cup 80. In one example, while the recovered-liquid storage tank 210 does not recover the rinse liquid in a case where a particle concentration in the rinse liquid trapped in the cup 80 is high, the recovered-liquid storage tank 210 may recover the rinse liquid when the particle concentration in the rinse liquid trapped in the cup 80 is low. Alternatively, the recovered-liquid storage tank 210 does not have to recover the recovered liquid trapped in the cup 80 again. It is noted that the recovered-liquid storage tank 210 may recover the chemical liquid trapped in the cup 80.

The drain mechanism 90 discharges the chemical liquid, the rinse liquid, and the processing liquid trapped in the cup 80 to the outside of the chamber 11. The drain mechanism 90 includes a piping 91 to discharge the chemical liquid, the rinse liquid, and the processing liquid trapped in the cup 80. One end of the piping 91 is connected to a bottom portion of the cup 80.

The drain mechanism 90 further includes a piping 92a, a valve 92b, a piping 94a, and a valve 94b. The piping 92a is connected to the piping 91. The chemical liquid and the rinse liquid trapped in the cup 80 flow from the piping 91 to the piping 92a. The valve 92b opens and closes a flow channel in the piping 92a. The valve 92b adjusts an opening degree of the piping 92a to adjust a flow rate of the liquid flowing in the piping 92a. Specifically, the valve 92b includes a valve body (not shown) with a valve seat provided in an interior, a valve element which opens/closes the valve seat, and an actuator (not shown) which moves the valve element between an open position and a closed position.

The piping 94a connects the piping 91 and the recovered-liquid storage tank 210. In the piping 94a, the rinse liquid trapped in the cup 80 flows from the piping 91. The valve 94b opens and closes a flow channel in the piping 94a. The valve 94b adjusts an opening degree of the piping 94a to adjust a flow rate of the rinse liquid flowing in the piping 94a. The valve 94b may have a configuration similar to that of the valve 92b.

In a case where the valve 94b is opened, the rinse liquid trapped in the cup 80 flows in the piping 94a to the recovered-liquid storage tank 210.

As described above, the controller 101 includes the controlling portion 102 and the storage portion 104. The controlling portion 102 controls the substrate holding portion 20, the chemical liquid supplying portion 30, and/or the cup 80. In one example, the controlling portion 102 controls the electric motor 24, the valves 36, 46, 54b, 56b, 58b, 92b, and 94b, and/or the cup 80.

The substrate processing apparatus 100 of the present preferred embodiment is suitably used for manufacturing a semiconductor device provided with a semiconductor. Typically, in a semiconductor device, a conductive layer and an insulating layer are laminated on a base material. The substrate processing apparatus 100 is suitably used for cleaning and/or processing (for example, etching, characteristic change, and the like) of the conductive layer and/or the insulating layer at the time of manufacturing the semiconductor device.

It is noted that, in the substrate processing unit 10 illustrated in FIG. 2, the chemical liquid supplying portion 30 can supply one type of processing liquid. However, the present preferred embodiment is not limited thereto. The chemical liquid supplying portion 30 may supply a plurality of types of chemical liquids. For example, the chemical liquid supplying portion 30 may be capable of sequentially supplying a plurality of types of chemical liquids for different purposes to the substrate W. Alternatively, the chemical liquid supplying portion 30 may be capable of simultaneously supplying a plurality of types of chemical liquids for different purposes to the substrate W.

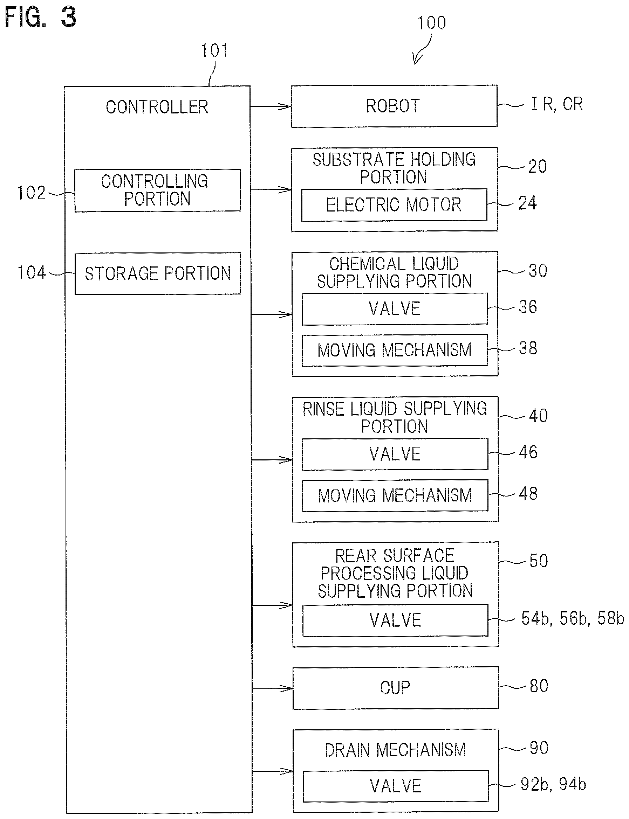

Next, the substrate processing apparatus 100 according to the present preferred embodiment will be described with reference to FIGS. 1 to 3. FIG. 3 is a block diagram of the substrate processing apparatus 100.

As illustrated in FIG. 3, the controller 101 controls various operations of the substrate processing apparatus 100. The controller 101 controls the indexer robot IR, the center robot CR, the substrate holding portion 20, the chemical liquid supplying portion 30, the rinse liquid supplying portion 40, the rear surface processing liquid supplying portion 50, the cup 80, and the drain mechanism 90. Specifically, the controller 101 controls the indexer robot IR, the center robot CR, the substrate holding portion 20, the chemical liquid supplying portion 30, the rinse liquid supplying portion 40, the rear surface processing liquid supplying portion 50, the cup 80, and the drain mechanism 90 by transmitting a control signal to the indexer robot IR, the center robot CR, the substrate holding portion 20, the chemical liquid supplying portion 30, the rinse liquid supplying portion 40, the rear surface processing liquid supplying portion 50, the cup 80, and the drain mechanism 90.

Also, the storage portion 104 stores a computer program and data. The data includes recipe data. The recipe data includes information indicating a plurality of recipes. Each of the plurality of recipes defines processing details, a processing procedure, and a substrate processing condition of the substrate W. The controlling portion 102 executes a computer program stored in the storage portion 104 to execute a substrate processing operation.

The controlling portion 102 controls the indexer robot IR to transfer the substrate W by the indexer robot IR.

The controlling portion 102 controls the center robot CR to transfer the substrate W by the center robot CR. For example, the center robot CR receives the unprocessed substrate W and carries the substrate W into one of the plurality of chambers 11. Also, the center robot CR receives the processed substrate W from the chamber 11 and carries out the substrate W.

The controlling portion 102 controls the substrate holding portion 20 to control a start of rotation of the substrate W, a change in rotation speed, and a stop of rotation of the substrate W. For example, the controlling portion 102 can control the substrate holding portion 20 to change a rotation speed of the substrate holding portion 20. Specifically, the controlling portion 102 can change a rotation speed of the substrate W by changing a rotation speed of the electric motor 24 of the substrate holding portion 20.

The controlling portion 102 can control the valve 36 of the chemical liquid supplying portion 30 to switch a state of the valve 36 between the open state and the closed state. Specifically, the controlling portion 102 can control the valve 36 of the chemical liquid supplying portion 30 to make the valve 36 in an open state, thereby enabling the chemical liquid flowing in the piping 32 toward the nozzle 34 to pass therethrough. Also, the controlling portion 102 can control the valve 36 of the chemical liquid supplying portion 30 to make the valve 36 in a closed state, thereby enabling the supply of the chemical liquid flowing in the piping 32 toward the nozzle 34 to be stopped.

The controlling portion 102 can control the valve 46 of the rinse liquid supplying portion 40 to switch a state of the valve 46 between the open state and the closed state. Specifically, the controlling portion 102 can control the valve 46 of the rinse liquid supplying portion 40 to make the valve 46 in an open state, thereby enabling the rinse liquid flowing in the piping 42 toward the nozzle 44 to pass therethrough. Also, the controlling portion 102 can control the valve 46 of the rinse liquid supplying portion 40 to make the valve 46 in a closed state, thereby enabling the supply the rinse liquid flowing in the piping 42 toward the nozzle 44 to be stopped.

The controlling portion 102 can control the valve 54b of the chemical liquid supplying portion 54 to switch a state of the valve 54b between the open state and the closed state. Specifically, the controlling portion 102 can control the valve 54b of the chemical liquid supplying portion 54 to make the valve 54b in an open state, thereby enabling the chemical liquid flowing in the piping 54a, the piping 52c, and the piping 52 toward the nozzle 51 to pass therethrough. Also, the controlling portion 102 can control the valve 54b of the chemical liquid supplying portion 54 to make the valve 54b in a closed state, thereby enabling the supply of the chemical liquid flowing in the piping 54a toward the nozzle 51 to be stopped.

The controlling portion 102 can control the valve 56b of the rinse liquid supplying portion 56 to switch a state of the valve 56b between the open state and the closed state. Specifically, the controlling portion 102 can control the valve 56b of the rinse liquid supplying portion 56 to make the valve 56b in an open state, thereby enabling the rinse liquid flowing in the piping 56a, the piping 52c, and the piping 52 toward the nozzle 51 to pass therethrough. Specifically, the controlling portion 102 can control the valve 56b of the rinse liquid supplying portion 56 to make the valve 56b in a closed state, thereby enabling the supply the rinse liquid flowing in the piping 56a toward the nozzle 51 to be stopped.

The controlling portion 102 can control the valve 58b of the recovered-liquid supplying portion 58 to switch a state of the valve 58b between the open state and the closed state. Specifically, the controlling portion 102 can control the valve 58b of the recovered-liquid supplying portion 58 to make the valve 58b in an open state, thereby enabling the recovered liquid flowing in the piping 58a, the piping 52c, and the piping 52 toward the nozzle 51 to pass therethrough. Also, the controlling portion 102 can control the valve 58b of the recovered-liquid supplying portion 58 to make the valve 58b in a closed state, thereby enabling the supply of the recovered liquid flowing in the piping 58a toward the nozzle 51 to be stopped.

The controlling portion 102 may control the cup 80 to move the cup 80 with respect to the substrate W. Specifically, the controlling portion 102 moves the cup 80 to an elevated position laterally to the substrate W in a period in which at least one of the chemical liquid supplying portion 30, the rinse liquid supplying portion 40, the chemical liquid supplying portion 54, the rinse liquid supplying portion 56, and the recovered-liquid supplying portion 58 supplies any one of the chemical liquid, the rinse liquid, and the recovered liquid to the substrate W. Also, when the period in which at least one of the chemical liquid supplying portion 30, the rinse liquid supplying portion 40, the chemical liquid supplying portion 54, the rinse liquid supplying portion 56, and the recovered-liquid supplying portion 58 supplies any one of the chemical liquid, the rinse liquid, and the recovered liquid to the substrate W ends, the controlling portion 102 lowers the cup 80 vertically downward from the lateral side of the substrate W.

The controlling portion 102 can control the valve 92b of the drain mechanism 90 to switch a state of the valve 92b between the open state and the closed state. Specifically, the controlling portion 102 can control the valve 92b to make the valve 92b in an open state, thereby enabling the chemical liquid and the rinse liquid flowing in the piping 91 and the piping 92a to pass therethrough. Specifically, the controlling portion 102 can control the valve 92b to make the valve 92b in a closed state, thereby enabling passing of the chemical liquid and the rinse liquid flowing in the piping 91 and the piping 92a to be stopped.

The controlling portion 102 can control the valve 94b of the drain mechanism 90 to switch a state of the valve 94b between the open state and the closed state. Specifically, the controlling portion 102 can control the valve 94b to make the valve 94b in an open state, thereby enabling the rinse liquid flowing in the piping 91 and the piping 94a to pass to the recovered-liquid storage tank 210. Also, the controlling portion 102 can control the valve 94b to make the valve 94b in a closed state, thereby enabling the rinse liquid flowing through the piping 91 and the piping 94a to be stopped from passing to the recovered-liquid storage tank 210.

The substrate processing apparatus 100 of the present preferred embodiment is suitably used for forming a semiconductor device. For example, the substrate processing apparatus 100 is suitably used for processing the substrate W used as a semiconductor device having a laminated structure. The semiconductor device is a memory (storage) having a so-called 3D structure. As an example, the substrate W is suitably used as a NAND type flash memory.

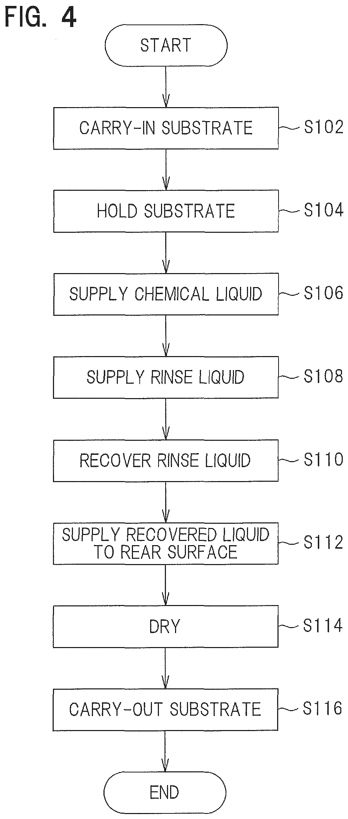

Next, the substrate processing apparatus 100 according to the present preferred embodiment will be described with reference to FIGS. 1 to 4. FIG. 4 is a flowchart of a substrate processing method according to the present preferred embodiment.

As illustrated in FIG. 4, in step S102, the substrate W is carried into the chamber 11. Under control of the controlling portion 102, the center robot CR carries the substrate W into the chamber 11. Here, the front surface Wa of the substrate W faces vertically upward, and the rear surface Wb of the substrate W faces vertically downward.

In step S104, the substrate holding portion 20 holds the carried-in substrate W. Under control of the controlling portion 102, the substrate holding portion 20 holds the substrate W.

In step S106, the rotation of the substrate W is started, and the chemical liquid is supplied to the substrate W. Under control of the controlling portion 102, the substrate holding portion 20 starts rotating the substrate W in a state of holding the substrate W. Also, under control of the controlling portion 102, the chemical liquid supplying portion 30 supplies the chemical liquid from the nozzle 34 to the front surface Wa of the substrate W.

It is noted that, while the chemical liquid is supplied from the nozzle 34 to the front surface Wa of the substrate W, the rear surface processing liquid supplying portion 50 may supply the chemical liquid from the nozzle 51 to the rear surface Wb of the substrate W under control of the controlling portion 102.

Under control of the controlling portion 102, the cup 80 is positioned at the upper position that covers the lateral side of the substrate W. The cup 80 may be elevated such as to be positioned laterally to the substrate W when the chemical liquid starts to be supplied from the nozzle 34 to the front surface Wa of the substrate W. It is noted that, the cup 80 may be elevated at the same timing as the start of supplying the processing liquid to the substrate W.

Under the control of the controlling portion 102, the valve 94b is closed while the valve 92b is in an open state. In this case, the cup 80 traps the chemical liquid scattering from the substrate W, and the chemical liquid trapped in the cup 80 flows and is discharged through the piping 92a in which the valve 92b is opened.

In step S108, the rinse liquid is supplied to the substrate W in a state in which the substrate W is rotated. Under control of the controlling portion 102, the substrate holding portion 20 continues rotating the substrate W in the state of holding the substrate W. Also, under control of the controlling portion 102, the rinse liquid supplying portion 40 supplies the rinse liquid from the nozzle 44 to the front surface Wa of the substrate W.

It is noted that, while the rinse liquid is supplied from the nozzle 44 to the front surface Wa of the substrate W, the rear surface processing liquid supplying portion 50 may supply the rinse liquid from the nozzle 51 to the rear surface Wb of the substrate W under control of the controlling portion 102.

Under control of the controlling portion 102, the cup 80 remains positioned at the upper position that covers the lateral side of the substrate W. Under the control of the controlling portion 102, the valve 94b remains closed while the valve 92b is in an open state. In this case, the cup 80 traps the rinse liquid scattering from the substrate W, and the rinse liquid trapped in the cup 80 flows and is discharged through the piping 91 and the piping 92a in which the valve 92b is opened.

In step S110, while the rinse liquid is supplied to the substrate W in a state in which the substrate W is rotated, the rinse liquid supplied to the substrate W is recovered. Under control of the controlling portion 102, the rinse liquid supplying portion 40 continues supplying the rinse liquid from the nozzle 44 to the front surface Wa of the substrate W in a state in which the substrate holding portion 20 rotates the substrate W.

It is noted that, while the rinse liquid is supplied from the nozzle 44 to the front surface Wa of the substrate W, the rear surface processing liquid supplying portion 50 may supply the rinse liquid from the nozzle 51 to the rear surface Wb of the substrate W under control of the controlling portion 102.

Under control of the controlling portion 102, the cup 80 remains positioned at the upper position that covers the lateral side of the substrate W. Under the control of the controlling portion 102, the valve 92b is closed, and the valve 94b is opened. In this case, the cup 80 traps the rinse liquid scattering from the substrate W, and the rinse liquid trapped in the cup 80 flows through the piping 91 into the piping 94a in which the valve 94b is opened, and the rinse liquid is recovered as the recovered liquid in the recovered-liquid storage tank 210.

In step S112, the recovered liquid is supplied to the substrate W in the state in which the substrate W is rotated. Under control of the controlling portion 102, the substrate holding portion 20 continues rotating the substrate W in the state of holding the substrate W. Under control of the controlling portion 102, the rinse liquid supplying portion 40 continues supplying the rinse liquid from the nozzle 44 to the front surface Wa of the substrate W. Under control of the controlling portion 102, the rear surface processing liquid supplying portion 50 supplies the recovered liquid from the nozzle 51 to the rear surface Wb of the substrate W.

Under control of the controlling portion 102, the cup 80 remains positioned at the upper position that covers the lateral side of the substrate W. The recovered-liquid storage tank 210 recovers the rinse liquid and the recovered liquid supplied to the substrate W. Under control of the controlling portion 102, the valve 92b is closed, and the valve 94b remains open. In this case, the cup 80 traps the rinse liquid and the recovered liquid scattering from the substrate W, and the rinse liquid and the recovered liquid trapped in the cup 80 flow through the piping 91 into the piping 94a in which the valve 94b is opened, and the rinse liquid and the recovered liquid are recovered as the recovered liquid in the recovered-liquid storage tank 210.

In step S114, the substrate W is dried. At this time, the supply of the rinse liquid and the recovered liquid is stopped, and the rotation speed of the substrate W is increased. Under control of the controlling portion 102, the chemical liquid supplying portion 30 stops supplying of the rinse liquid from the nozzle 34 to the front surface Wa of the substrate W. Also, under control of the controlling portion 102, the supply of the recovered liquid from the nozzle 51 to the rear surface Wb of the substrate W is stopped. Further, under the control of the controlling portion 102, the substrate holding portion 20 increases the rotation speed of the substrate W.

Also, under control of the controlling portion 102, the cup 80 remains positioned at the upper position that covers the lateral side of the substrate W. Under the control of the controlling portion 102, the valve 92b is closed, and the valve 94b is opened. In this case, the cup 80 traps the rinse liquid and the recovered liquid scattering from the substrate W, and the rinse liquid and the recovered liquid trapped in the cup 80 flow through the piping 91 into the piping 94a in which the valve 94b is opened, and the rinse liquid and the recovered liquid are recovered as the recovered liquid in the recovered-liquid storage tank 210. Thereafter, under control of the controlling portion 102, the substrate holding portion 20 stops the rotation of the substrate W.

In step S116, the substrate W is carried out from the substrate processing unit 10. Under control of the controlling portion 102, the substrate holding portion 20 releases the holding of the substrate W, and the center robot CR takes out the substrate W from the chamber 11. Thereafter, the substrate W is carried to the outside of the substrate processing apparatus 100 through the indexer robot IR.

In the present preferred embodiment, the front surface Wa of the substrate W is processed with the chemical liquid as described above, and then processed with the rinse liquid. According to the present preferred embodiment, in at least a part of the period in which the rinse liquid supplying portion 40 supplies the rinse liquid to the front surface Wa of the substrate W, the recovered liquid is supplied to the rear surface Wb of the substrate W. Therefore, the substrate processing apparatus 100 according to the present preferred embodiment can reduce the use amount of a new processing liquid.

Also, in the present preferred embodiment, in a period in which the rinse liquid is supplied to the front surface Wa of the substrate W, the rinse liquid used in processing the substrate W after a predetermined time elapses is recovered as the recovered liquid. Consequently, since the rinse liquid containing relatively less impurities can be recovered as the recovered liquid, it is possible to prevent the occurrence of a defect when the recovered liquid is supplied to the rear surface Wb of the substrate W.

Also, in the present preferred embodiment, in the period in which the rinse liquid is supplied to the front surface Wa of the substrate W, the recovered liquid is supplied to the rear surface Wb of the substrate W after a predetermined time elapses. Consequently, at the start of the rinse processing, since the rinse liquid containing relatively less impurities is supplied also to the rear surface Wb of the substrate W, it is possible to more appropriately perform the rinse processing on the substrate W.

It is noted that, in the above description, the supply of the recovered liquid to the rear surface Wb of the substrate W in step S112 is started after the recovery of the recovered liquid in step S110, but the present preferred embodiment is not limited thereto. The supply of the recovered liquid to the rear surface Wb of the substrate W in step S112 may be started at the same time as the recovery of the recovered liquid in step S110. Alternatively, the supply of the recovered liquid to the rear surface Wb of the substrate W in step S112 may be started after the recovery of the recovered liquid in step S110.

Also, in step S112 described above, the recovered liquid obtained by recovering the rinse liquid supplied to the front surface Wa and the rear surface Wb of the substrate W in the chamber 11 by the rinse liquid supplying portion 40 and the rinse liquid supplying portion 56 in step S110 is supplied to the rear surface Wb of the substrate W, but the present preferred embodiment is not limited thereto. In step S112, the recovered-liquid supplying portion 58 may recover the rinse liquid supplied to the substrate W previously processed in the chamber 11 and may supply the recovered rinse liquid as the recovered liquid to the current rear surface Wb of the substrate W. Alternatively, in step S112, the recovered-liquid supplying portion 58 may recover the rinse liquid used to process the substrate W in another chamber 11 and supply the recovered rinse liquid as the recovered liquid to the rear surface Wb of the substrate W. Also, in step S110, the recovered liquid recovered in the recovered-liquid storage tank 210 may be supplied to the rear surface Wb of the next substrate W in the chamber 11, or may be supplied to the rear surface Wb of the substrate W accommodated in another chamber 11.

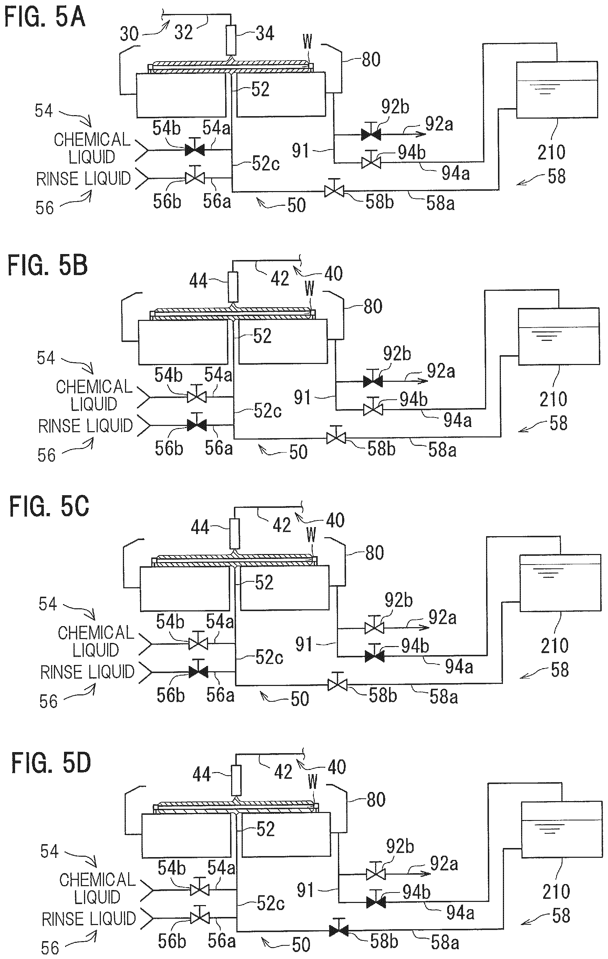

Next, the substrate processing apparatus 100 according to the present preferred embodiment will be described with reference to FIGS. 1 to 5D. FIGS. 5A to 5D are schematic diagrams showing a flow of the substrate processing apparatus 100 according to the present preferred embodiment.

As illustrated in FIG. 5A, the chemical liquid is supplied to the front surface Wa and the rear surface Wb of the substrate W, and the front surface Wa and the rear surface Wb of the substrate W are processed with the chemical liquid. FIG. 5A illustrates an example of step S106 in FIG. 4. The chemical liquid supplying portion 30 supplies the chemical liquid to the front surface Wa of the rotating substrate W. The rear surface processing liquid supplying portion 50 supplies the chemical liquid to the rear surface Wb of the rotating substrate W. Here, the cup 80 is positioned at the upper position. Therefore, the cup 80 faces the side portion of the substrate W. The cup 80 traps the chemical liquid scattering in accompaniment with the rotation of the substrate W.

In the drain mechanism 90, the valve 92b is opened while the valve 94b is closed. Therefore, the chemical liquid trapped in the cup 80 flows and is discharged through the piping 91 and the piping 92a.

As illustrated in FIG. 5B, the rinse liquid is supplied to the front surface Wa and the rear surface Wb of the substrate W, and the front surface Wa and the rear surface Wb of the substrate W are processed with the rinse liquid. FIG. 5B illustrates an example of step S108 in FIG. 4. The rinse liquid supplying portion 40 supplies the rinse liquid to the front surface Wa of the rotating substrate W. The rear surface processing liquid supplying portion 50 supplies the rinse liquid to the rear surface Wb of the rotating substrate W. The cup 80 traps the rinse liquid scattering in accompaniment with the rotation of the substrate W.

In the drain mechanism 90, the valve 92b is opened, and the valve 94b remains closed. Therefore, the rinse liquid trapped in the cup 80 flows and is discharged through the piping 91 and the piping 92a.

As shown in FIG. 5C, the rinse liquid is supplied to the front surface Wa and the rear surface Wb of the substrate W, and the front surface Wa and the rear surface Wb of the substrate W are processed with the rinse liquid. FIG. 5C illustrates an example of step S110 in FIG. 4. The rinse liquid supplying portion 40 continues supplying the rinse liquid to the front surface Wa of the rotating substrate W, and the rear surface processing liquid supplying portion 50 continues supplying the rinse liquid to the rear surface Wb of the rotating substrate W. Here, the cup 80 traps the rinse liquid scattering in accompaniment with the rotation of the substrate W.

In the drain mechanism 90, the valve 94b is opened while the valve 92b is closed. Therefore, the rinse liquid trapped in the cup 80 flows through the piping 91 and the piping 94a and flows to be recovered in the recovered-liquid storage tank 210.

As shown in FIG. 5D, the rinse liquid is supplied to the front surface Wa of the substrate W to process the front surface Wa of the substrate W with the rinse liquid, and the recovered liquid is supplied to the rear surface Wb of the substrate W to process the rear surface Wb of the substrate W with the recovered liquid. FIG. 5D shows an example of step S112 in FIG. 4. For example, the rinse liquid supplying portion 40 continues supplying the rinse liquid to the front surface Wa of the rotating substrate W. The rear surface processing liquid supplying portion 50 supplies the recovered liquid to the rear surface Wb of the rotating substrate W. The cup 80 traps the rinse liquid scattering in accompaniment with the rotation of the substrate W and traps the recovered liquid scattering in accompaniment with the rotation of the substrate W again.

In the drain mechanism 90, the valve 94b is opened, and the valve 92b remains closed. Therefore, the rinse liquid and the recovered liquid trapped in the cup 80 flow through the piping 91 and the piping 94a and flow to be recovered in the recovered-liquid storage tank 210.

Thereafter, the rinse liquid supplying portion 40 stops the supply of the rinse liquid, and the rear surface processing liquid supplying portion 50 stops the supply of the recovered liquid. At this time, the substrate holding portion 20 may dry the substrate W by increasing the rotation speed of the substrate W. Thereafter, the substrate holding portion 20 stops the rotation of the substrate W, and the substrate W is carried out from the chamber 11.

According to the present preferred embodiment, the front surface Wa of the substrate W is processed with the chemical liquid as described above, and then processed with the rinse liquid. According to the present preferred embodiment, in at least a part of the period in which the rinse liquid supplying portion 40 supplies the rinse liquid to the front surface Wa of the substrate W, the recovered liquid is supplied to the rear surface Wb of the substrate W. Therefore, the substrate processing apparatus 100 according to the present preferred embodiment can reduce the use amount of a new processing liquid.

It is noted that, in the description with reference to FIGS. 4 and 5A to 5D, in the period in which the rinse liquid supplying portion 40 supplies the rinse liquid to the front surface Wa of the substrate W, the rear surface processing liquid supplying portion 50 supplies the rinse liquid to the rear surface Wb of the substrate W and then supplies the recovered liquid to the rear surface Wb, but the present preferred embodiment is not limited thereto. In the period in the rinse liquid supplying portion 40 supplies the rinse liquid to the front surface Wa of the substrate W, the rear surface processing liquid supplying portion 50 may supply the recovered liquid without supplying the rinse liquid to the rear surface Wb of the substrate W. In this case, the rear surface processing liquid supplying portion 50 does not have to include the rinse liquid supplying portion 56.

Also, in the substrate processing apparatus 100 shown in FIGS. 1 to 5D, the rear surface processing liquid supplying portion 50 can selectively supply the recovered liquid and the rinse liquid to the rear surface Wb of the substrate W, but the present preferred embodiment is not limited thereto. The rear surface processing liquid supplying portion 50 may supply only the recovered liquid to the rear surface Wb of the substrate W.

Specifically, in the substrate processing apparatus 100 shown in FIG. 4, the rear surface processing liquid supplying portion 50 includes the chemical liquid supplying portion 54, the rinse liquid supplying portion 56, and the recovered-liquid supplying portion 58, and in the substrate processing method described above with reference to FIGS. 5A to 5D, the chemical liquid, the rinse liquid, and the recovered liquid are selectively supplied to the rear surface Wb of the substrate W, but the present preferred embodiment is not limited thereto. The rear surface processing liquid supplying portion 50 does not have to include the chemical liquid supplying portion 54 and the rinse liquid supplying portion 56, while including the recovered-liquid supplying portion 58. In this case, the rear surface Wb of the substrate W may be supplied with the recovered liquid, without being supplied with the chemical liquid and the rinse liquid.

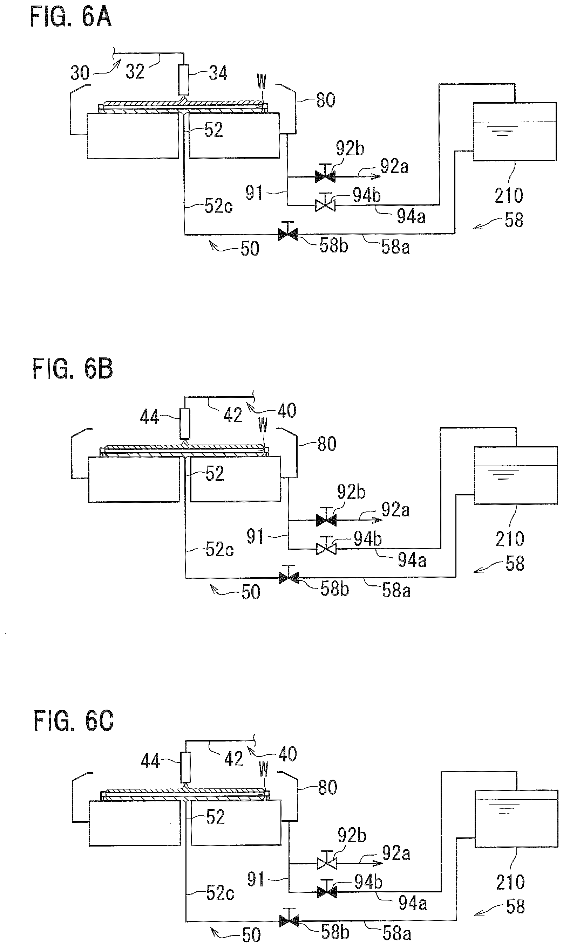

Next, the substrate processing apparatus 100 according to the present preferred embodiment will be described with reference to FIGS. 1 to 6C. FIGS. 6A to 6C are schematic diagrams showing a flow of the substrate processing apparatus 100 according to the present preferred embodiment.

As shown in FIG. 6A, the chemical liquid is supplied to the front surface Wa of the substrate W so that the front surface Wa of the substrate W is processed with the chemical liquid, and the recovered liquid is supplied to the rear surface Wb of the substrate W so that the rear surface Wb of the substrate W is processed with the recovered liquid. The rinse liquid supplying portion 40 supplies the rinse liquid to the front surface Wa of the rotating substrate W. The rear surface processing liquid supplying portion 50 supplies the recovered liquid to the rear surface Wb of the substrate W.

Here, the cup 80 is positioned at the upper position and faces the side portion of the substrate W. The cup 80 recovers the chemical liquid and the recovered liquid scattering in accompaniment with the rotation of the substrate W.

In the drain mechanism 90, the valve 92b is opened, and the valve 94b is closed. Therefore, the chemical liquid and the recovered liquid trapped in the cup 80 flow and are discharged through the piping 91 and the piping 92a.

As shown in FIG. 6B, the rinse liquid is supplied to the front surface Wa of the substrate W so that the front surface Wa of the substrate W is processed with the rinse liquid, and the recovered liquid is supplied to the rear surface Wb of the substrate W so that the rear surface Wb of the substrate W is processed with the recovered liquid. For example, the rinse liquid supplying portion 40 supplies the rinse liquid to the front surface Wa of the rotating substrate W. The rear surface processing liquid supplying portion 50 continues supplying the recovered liquid to the rear surface Wb of the rotating substrate W. Here, the cup 80 traps the rinse liquid and the recovered liquid scattering in accompaniment with the rotation of the substrate W again.

In the drain mechanism 90, the valve 92b is opened, and the valve 94b remains closed. Therefore, the rinse liquid and the recovered liquid trapped in the cup 80 flow and are discharged through the piping 91 and the piping 92a.

As shown in FIG. 6C, the rinse liquid is supplied to the front surface Wa of the substrate W so that the front surface Wa of the substrate W is processed with the rinse liquid, and the recovered liquid is supplied to the rear surface Wb of the substrate W so that the rear surface Wb of the substrate W is processed with the recovered liquid. The rinse liquid supplying portion 40 continues supplying the rinse liquid to the front surface Wa of the rotating substrate W, and the rear surface processing liquid supplying portion 50 continues supplying the recovered liquid to the rear surface Wb of the rotating substrate W. Here, the cup 80 traps the rinse liquid and the recovered liquid scattering in accompaniment with the rotation of the substrate W again.

In the drain mechanism 90, the valve 94b is opened while the valve 92b is closed. Therefore, the rinse liquid and the recovered liquid trapped in the cup 80 flow through the piping 91 and the piping 94a and flow to be recovered in the recovered-liquid storage tank 210.

Thereafter, the rinse liquid supplying portion 40 stops the supply of the rinse liquid, and the rear surface processing liquid supplying portion 50 stops the supply of the recovered liquid. At this time, the substrate holding portion 20 may dry the substrate W by increasing the rotation speed of the substrate W. Thereafter, the substrate holding portion 20 stops the rotation of the substrate W, and the substrate W is carried out from the chamber 11.

In the present preferred embodiment, the front surface Wa of the substrate W is processed with the chemical liquid as described above, and then processed with the rinse liquid. According to the present preferred embodiment, in the period in which the chemical liquid and the rinse liquid are supplied to the front surface Wa of the substrate W, the recovered liquid is supplied to the rear surface Wb of the substrate W. Therefore, the substrate processing apparatus 100 according to the present preferred embodiment can reduce the use amount of a new processing liquid.

It is noted that, in the above description with reference to FIGS. 1 to 6C, the rear surface processing liquid supplying portion 50 includes the chemical liquid supplying portion 54 together with the rinse liquid supplying portion 56, but the present preferred embodiment is not limited thereto. The rear surface processing liquid supplying portion 50 may include the chemical liquid supplying portion 54 without including the rinse liquid supplying portion 56.

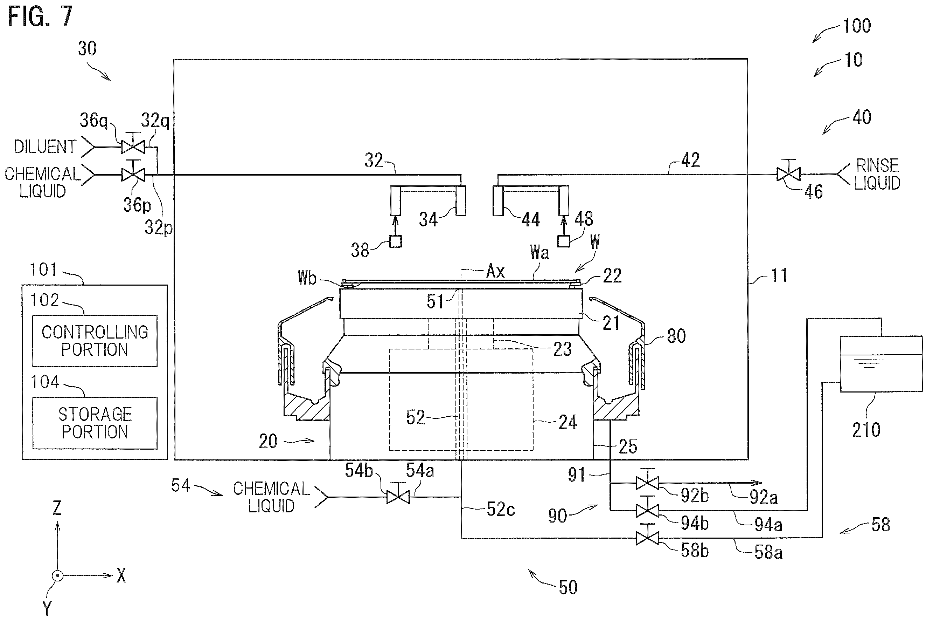

Next, the substrate processing apparatus 100 according to the present preferred embodiment will be described with reference to FIGS. 1 to 7. FIG. 7 is a schematic diagram of the substrate processing apparatus 100 according to the present preferred embodiment. The substrate processing unit 10 in FIG. 7 has the same configuration as the substrate processing apparatus 100 shown in FIG. 2 except that a diluted chemical liquid obtained by diluting the chemical liquid with a diluent is supplied to the front surface Wa of the substrate W, and a diluted chemical liquid obtained by diluting the chemical liquid with the recovered liquid is supplied to the rear surface Wb of the substrate W, and redundant description is omitted for the purpose of avoiding the lengthy description.

As shown in FIG. 7, in the substrate processing unit 10, the chemical liquid supplying portion 30 supplies the diluted chemical liquid obtained by diluting the chemical liquid with the diluent to the front surface Wa of the substrate W.

The chemical liquid supplying portion 30 includes the piping 32, the nozzle 34, a piping 32p, a valve 36p, a piping 32q, and a valve 36q. The nozzle 34 is connected to one end of the piping 32.

The piping 32p is connected to the other end of the piping 32. The chemical liquid is supplied from the supply source to the piping 32p. The valve 36p opens and closes a flow channel in the piping 32p. When the valve 36p is opened, the chemical liquid flows in the piping 32p.

The chemical liquid contains, for example, hydrofluoric acid. The chemical liquid may contain phosphoric acid. Also, the chemical liquid may contain hydrogen peroxide water. The chemical liquid may contain SC1 (a mixture liquid of ammonia and hydrogen peroxide water), SC2 (a mixture liquid of hydrochloric acid and hydrogen peroxide water), or aqua regia (a mixture of concentrated hydrochloric acid and concentrated nitric acid).

The piping 32q is connected to the other end of the piping 32. The diluent is supplied from a supply source to the piping 32q. The valve 36q opens and closes a flow channel in the piping 32q. When the valve 36q is opened, the diluent flows in the piping 32q.

The diluent may contain, for example, any one of, for example, deionized water (DIW), carbonated water, electrolyzed ion water, ozone water, ammonia water, hydrochloric acid solution with a diluted concentration (for example, about 10 ppm to 100 ppm), or reduced water (hydrogen water). It is noted that, the diluent may be of the same type as the rinse liquid.

When the valve 36p and the valve 36q are opened, the chemical liquid and the diluent flow in the piping 32p and the piping 32q, respectively, whereby the diluted chemical liquid obtained by diluting the chemical liquid with the diluent flow in the piping 32. The nozzle 34 discharges the diluted chemical liquid onto the front surface Wa of the substrate W.

The rear surface processing liquid supplying portion 50 supplies only the recovered liquid or a mixture of the chemical liquid and the recovered liquid to the rear surface Wb of the substrate W. The rear surface processing liquid supplying portion 50 includes the chemical liquid supplying portion 54 and the recovered-liquid supplying portion 58. On the other hand, the substrate processing apparatus 100 shown in FIG. 7 differs from the substrate processing apparatus 100 shown in FIG. 2 in that the rear surface processing liquid supplying portion 50 does not include the rinse liquid supplying portion 56.

For example, the rear surface processing liquid supplying portion 50 may supply the recovered liquid to the rear surface Wb of the substrate W. Also, the rear surface processing liquid supplying portion 50 may mix the chemical liquid and the recovered liquid and supply the mixture to the rear surface Wb of the substrate W.

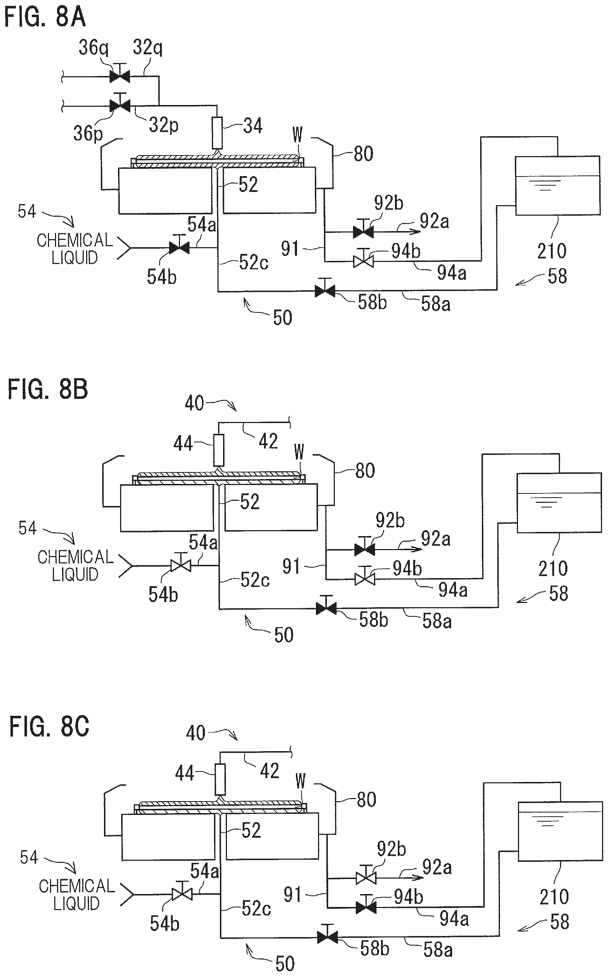

Next, the substrate processing apparatus 100 according to the present preferred embodiment will be described with reference to FIGS. 1 to 8C. FIGS. 8A to 8C are schematic diagrams showing a flow of the substrate processing apparatus 100 according to the present preferred embodiment. The flow shown in FIGS. 8A to 8C is similar to the flow of the substrate processing apparatus 100 shown in FIGS. 5A to 5D except that the substrate W is processed with a diluted chemical liquid, and redundant description is omitted in order to avoid the lengthy description.

As shown in FIG. 8A, the diluted chemical liquid is supplied to the front surface Wa and the rear surface Wb of the substrate W, and the front surface Wa and the rear surface Wb of the substrate W are processed with the diluted chemical liquid. The chemical liquid supplying portion 30 supplies the diluted chemical liquid to the front surface Wa of the rotating substrate W. Here, the valve 36p and the valve 36q are open, and the nozzle 34 discharges the diluted chemical liquid to the front surface Wa of the substrate W.

The rear surface processing liquid supplying portion 50 supplies the diluted chemical liquid to the rear surface Wb of the rotating substrate W. The valve 54b and the valve 58b are open. Therefore, the chemical liquid flowing in the piping 54a and the recovered liquid flowing in the piping 58a are mixed in the piping 52c to generate a diluted chemical liquid. Thereafter, the nozzle 51 discharges the diluted chemical liquid to the rear surface Wb of the substrate W.

Here, the cup 80 is positioned at the upper position and faces the side portion of the substrate W. In this case, the cup 80 traps the diluted chemical liquid scattering from the substrate W in accompaniment with the rotation of the substrate W.

In the drain mechanism 90, the valve 92b is opened while the valve 94b is closed. Therefore, the diluted chemical liquid trapped in the cup 80 flows and is discharged through the piping 91 and the piping 92a.

As shown in FIG. 8B, the rinse liquid is supplied to the front surface Wa of the substrate W so that the front surface Wa of the substrate W is processed with the rinse liquid, and the recovered liquid is supplied to the rear surface Wb of the substrate W so that the rear surface Wb of the substrate W is processed with the recovered liquid. The rinse liquid supplying portion 40 supplies the rinse liquid to the front surface Wa of the rotating substrate W. The rear surface processing liquid supplying portion 50 supplies the recovered liquid to the rear surface Wb of the rotating substrate W. In the rear surface processing liquid supplying portion 50, the valve 54b is closed such that the supply of the chemical liquid is stopped. The cup 80 traps the rinse liquid and the recovered liquid scattering in accompaniment with the rotation of the substrate W.

In the drain mechanism 90, the valve 92b is opened, and the valve 94b remains closed. Therefore, the rinse liquid and the recovered liquid trapped in the cup 80 flow and are discharged through the piping 91 and the piping 92a.

As shown in FIG. 8C, the rinse liquid is supplied to the front surface Wa of the substrate W so that the front surface Wa of the substrate W is processed with the rinse liquid, and the recovered liquid is supplied to the rear surface Wb of the substrate W so that the rear surface Wb of the substrate W is processed with the recovered liquid. The rinse liquid supplying portion 40 continues supplying the rinse liquid to the front surface Wa of the rotating substrate W. The rear surface processing liquid supplying portion 50 continues supplying the recovered liquid to the rear surface Wb of the rotating substrate W. Here, the cup 80 traps the rinse liquid and the recovered liquid scattering in accompaniment with the rotation of the substrate W.

In the drain mechanism 90, the valve 92b is closed while the valve 94b is opened. Therefore, the rinse liquid and the recovered liquid trapped in the cup 80 flow through the piping 91 and the piping 94a and are stored in the recovered-liquid storage tank 210. The recovered-liquid supplying portion 58 supplies the recovered liquid stored in the recovered-liquid storage tank 210 to the rear surface Wb of the substrate W.

Thereafter, the rinse liquid supplying portion 40 stops the supply of the rinse liquid, and the rear surface processing liquid supplying portion 50 stops the supply of the recovered liquid. At this time, the substrate holding portion 20 may dry the substrate W by increasing the rotation speed of the substrate W. Thereafter, the substrate holding portion 20 stops the rotation of the substrate W, and the substrate W is carried out from the chamber 11.

According to the present preferred embodiment, the front surface Wa of the substrate W is processed with the diluted chemical liquid as described above, and then processed with the rinse liquid. According to the present preferred embodiment, in a period in which the diluted chemical liquid and the rinse liquid are supplied to the front surface Wa of the substrate W, the recovered liquid is supplied to the rear surface Wb of the substrate W as at least a part of the processing liquid. Therefore, the substrate processing apparatus 100 according to the present preferred embodiment can reduce the use amount of a new processing liquid.

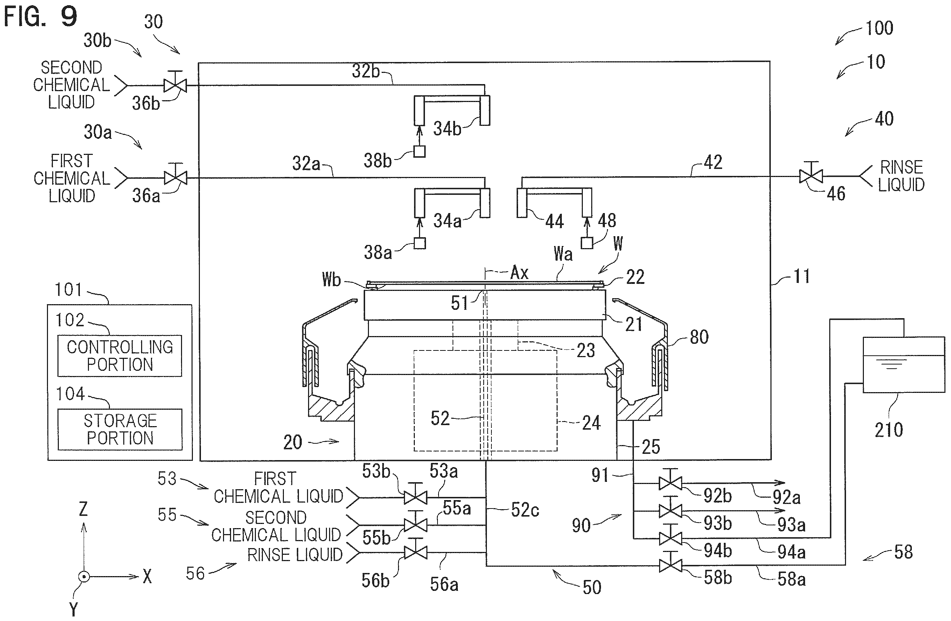

Next, the substrate processing apparatus 100 according to the present preferred embodiment will be described with reference to FIGS. 1 to 9. FIG. 9 is a schematic diagram of the substrate processing apparatus 100 according to the present preferred embodiment. The substrate processing apparatus 100 of FIG. 9 has the same configuration as the substrate processing apparatus 100 shown in FIG. 2 except that a first chemical liquid and a second chemical liquid are supplied to the substrate W, and redundant description is omitted for the purpose of avoiding the lengthy description.

As shown in FIG. 9, the chemical liquid supplying portion 30 includes a first chemical liquid supplying portion 30a and a second chemical liquid supplying portion 30b. The first chemical liquid supplying portion 30a supplies the first chemical liquid to the front surface Wa of the substrate W. The second chemical liquid supplying portion 30b supplies the second chemical liquid different from the first chemical liquid to the front surface Wa of the substrate W. For example, the first chemical liquid supplying portion 30a supplies hydrofluoric acid to the front surface Wa of the substrate W, and the second chemical liquid supplying portion 30b supplies a mixture liquid of ammonia and hydrogen peroxide water (SC1) to the front surface Wa of the substrate W.

The first chemical liquid supplying portion 30a includes a piping 32a, a nozzle 34a, and a valve 36a. The nozzle 34a is connected to the piping 32a. The first chemical liquid is supplied from a supply source to the piping 32a. The valve 36a opens and closes a flow channel in the piping 32a. The nozzle 34a discharges the first chemical liquid to the front surface Wa of the substrate W.

The valve 36a adjusts an opening degree of the piping 32a to adjust a flow rate of the first chemical liquid supplied to the piping 32a. Specifically, the valve 36a includes a valve body (not shown) with a valve seat provided in an interior, a valve element which opens/closes the valve seat, and an actuator (not shown) which moves the valve element between an open position and a closed position.

The nozzle 34a may be movable. The first chemical liquid supplying portion 30a may further include a nozzle moving portion 38a. The nozzle moving portion 38a may elevate and lower the nozzle 34a, and may horizontally rotate the nozzle 34a around a rotation axis. The nozzle moving portion 38a elevates and lowers the nozzle 34a. For example, the nozzle moving portion 38a includes a ball screw mechanism and an electric motor that applies a driving force to the ball screw mechanism. Also, the nozzle moving portion 38a horizontally rotates the nozzle 34. For example, the nozzle moving portion 38a includes an electric motor.

The second chemical liquid supplying portion 30b includes a piping 32b, a nozzle 34b, and a valve 36b. The nozzle 34b is connected to the piping 32b. The second chemical liquid is supplied from a supply source to the piping 32b. The valve 36b opens and closes a flow channel in the piping 32b. The nozzle 34b discharges the second chemical liquid to the front surface Wa of the substrate W. The piping 32b, the nozzle 34b, the valve 36b, and a nozzle moving portion 38b in the second chemical liquid supplying portion 30b have the same configurations as the piping 32a, the nozzle 34a, the valve 36a, and the nozzle moving portion 38a in the first chemical liquid supplying portion 30a, and redundant description will be omitted.

The rear surface processing liquid supplying portion 50 includes a first chemical liquid supplying portion 53 and a second chemical liquid supplying portion 55. The first chemical liquid supplying portion 53 supplies the first chemical liquid to the rear surface Wb of the substrate W. The second chemical liquid supplying portion 55 supplies the second chemical liquid different from the first chemical liquid to the rear surface Wb of the substrate W. For example, the first chemical liquid supplying portion 53 supplies hydrofluoric acid to the rear surface Wb of the substrate W, and the second chemical liquid supplying portion 55 supplies SC1 (a mixture liquid of ammonia and hydrogen peroxide water) to the rear surface Wb of the substrate W.

The first chemical liquid supplying portion 53 includes a piping 53a and a valve 53b. The first chemical liquid is supplied from a supply source to the piping 53a. The valve 53b opens and closes a flow channel in the piping 53a.

The valve 53b adjusts an opening degree of the piping 53a to adjust a flow rate of the first chemical liquid supplied to the piping 53a. Specifically, the valve 53b includes a valve body (not shown) with a valve seat provided in an interior, a valve element which opens/closes the valve seat, and an actuator (not shown) which moves the valve element between an open position and a closed position.

The second chemical liquid supplying portion 55 includes a piping 55a and a valve 55b. The second chemical liquid is supplied from the supply source to the piping 55a. The valve 55b opens and closes a flow channel in the piping 55a. The piping 55a and the valve 55b in the second chemical liquid supplying portion 55 have the same configurations as the piping 53a and the valve 53b in the first chemical liquid supplying portion 53, and redundant description will be omitted.

The drain mechanism 90 further includes a piping 93a and a valve 93b in addition to the piping 92a, the valve 92b, the piping 94a, and the valve 94b. The piping 92a is connected to the piping 91. The first chemical liquid and the rinse liquid trapped in the cup 80 flow from the piping 91 to the piping 92a.

The piping 93a is connected to the piping 91. The second chemical liquid and the rinse liquid trapped in the cup 80 flow from the piping 91 to the piping 93a. The valve 93b opens and closes a flow channel in the piping 93a. The valve 93b adjusts an opening degree of the piping 93a to adjust a flow rate of the chemical liquid flowing in the piping 93a. Specifically, the valve 93b includes a valve body (not shown) with a valve seat provided in an interior, a valve element which opens/closes the valve seat, and an actuator (not shown) which moves the valve element between an open position and a closed position.

It is noted that, the recovered liquid may flow in at least one of the piping 92a and the piping 93a.

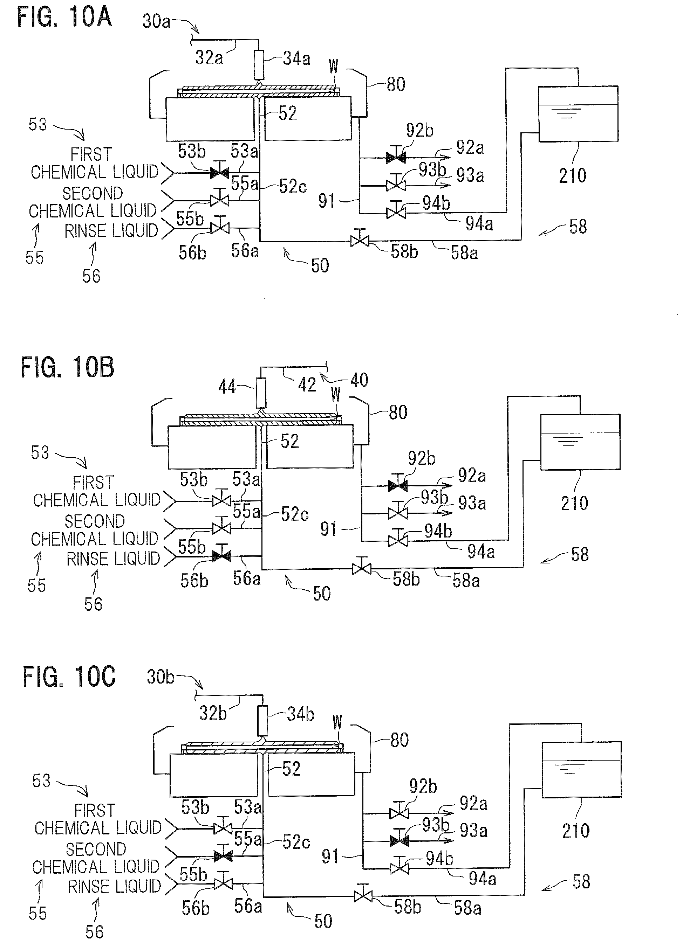

Next, the substrate processing apparatus 100 according to the present preferred embodiment will be described with reference to FIGS. 1 to 11C. FIGS. 10A to 11C are schematic diagrams showing a flow of the substrate processing apparatus 100 according to the present preferred embodiment. The flow in FIGS. 10A to 11C is similar to the flow of the substrate processing apparatus 100 shown in FIGS. 5A to 5D except that two types of chemical liquids and the rinse liquid are alternately supplied to the substrate W, and redundant description is omitted for the purpose of avoiding the lengthy description.

As shown in FIG. 10A, the first chemical liquid is supplied to the front surface Wa and the rear surface Wb of the substrate W, and the front surface Wa and the rear surface Wb of the substrate W are processed with the first chemical liquid. The first chemical liquid supplying portion 30a supplies the first chemical liquid to the front surface Wa of the rotating substrate W. The rear surface processing liquid supplying portion 50 supplies the first chemical liquid to the rear surface Wb of the rotating substrate W. In this case, the cup 80 traps the first chemical liquid scattering in accompaniment with the rotation of the substrate W.

In the drain mechanism 90, the valve 92b is opened, while the valves 93b and 94b are closed. Therefore, the first chemical liquid trapped in the cup 80 flows and is discharged through the piping 91 and the piping 92a.

As shown in FIG. 10B, the rinse liquid is supplied to the front surface Wa and the rear surface Wb of the substrate W, and the front surface Wa and the rear surface Wb of the substrate W are processed with the rinse liquid. The rinse liquid supplying portion 40 supplies the rinse liquid to the front surface Wa of the rotating substrate W. The rear surface processing liquid supplying portion 50 supplies the rinse liquid to the rear surface Wb of the rotating substrate W. The cup 80 traps the rinse liquid scattering in accompaniment with the rotation of the substrate W.

In the drain mechanism 90, the valve 92b is opened, and the valves 93b and 94b remain closed. Therefore, the rinse liquid trapped in the cup 80 flows and is discharged through the piping 91 and the piping 92a.

As shown in FIG. 10C, the second chemical liquid is supplied to the front surface Wa and the rear surface Wb of the substrate W, and the front surface Wa and the rear surface Wb of the substrate W are processed with the second chemical liquid. The second chemical liquid supplying portion 30b supplies the second chemical liquid to the front surface Wa of the rotating substrate W. The rear surface processing liquid supplying portion 50 supplies the second chemical liquid to the rear surface Wb of the rotating substrate W. The cup 80 traps the second chemical liquid scattering in accompaniment with the rotation of the substrate W.

In the drain mechanism 90, the valve 93b is opened while the valves 92b and 94b are closed. Therefore, the second chemical liquid trapped in the cup 80 flows and is discharged through the piping 91 and the piping 93a.

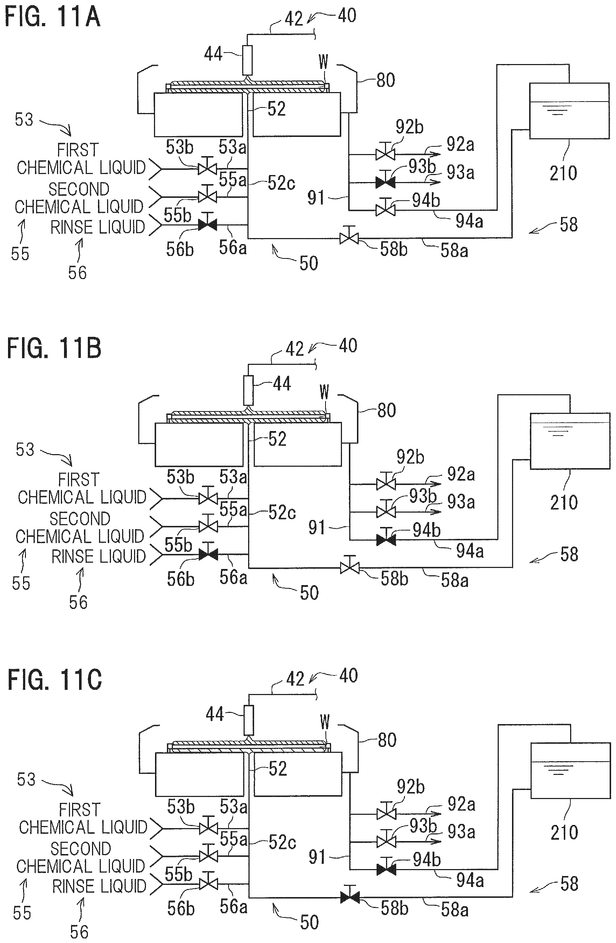

As shown in FIG. 11A, the rinse liquid is supplied to the front surface Wa and the rear surface Wb of the substrate W, and the front surface Wa and the rear surface Wb of the substrate W are processed with the rinse liquid. The rinse liquid supplying portion 40 supplies the rinse liquid to the front surface Wa of the rotating substrate W. The rear surface processing liquid supplying portion 50 supplies the rinse liquid to the rear surface Wb of the rotating substrate W. The cup 80 traps the rinse liquid scattering in accompaniment with the rotation of the substrate W.

In the drain mechanism 90, the valve 93b is opened, and the valves 92b and 94b remain closed. Therefore, the rinse liquid trapped in the cup 80 flows and is discharged through the piping 91 and the piping 93a.

As shown in FIG. 11B, the rinse liquid is supplied to the front surface Wa and the rear surface Wb of the substrate W, and the front surface Wa and the rear surface Wb of the substrate W are processed with the rinse liquid. The rinse liquid supplying portion 40 continues supplying the rinse liquid to the front surface Wa of the rotating substrate W. The rear surface processing liquid supplying portion 50 continues supplying the rinse liquid to the rear surface Wb of the substrate W. In this case, the cup 80 traps the rinse liquid scattering in accompaniment with the rotation of the substrate W.

In the drain mechanism 90, the valve 94b is opened, and the valves 92b and 93b are closed. Therefore, the rinse liquid trapped in the cup 80 flows through the piping 91 and the piping 94a and flows to the recovered-liquid storage tank 210.

As shown in FIG. 11C, the rinse liquid is supplied to the front surface Wa of the substrate W to process the front surface Wa of the substrate W with the rinse liquid, and the recovered liquid is supplied to the rear surface Wb of the substrate W to process the rear surface Wb of the substrate W with the recovered liquid. The rinse liquid supplying portion 40 supplies the rinse liquid to the front surface Wa of the rotating substrate W. The rear surface processing liquid supplying portion 50 supplies the recovered liquid to the rear surface Wb of the substrate W. In this case, the cup 80 recovers the rinse liquid and the recovered liquid scattering in accompaniment with the rotation of the substrate W.

In the drain mechanism 90, the valve 94b is opened, and the valves 92b and 93b remain closed. Therefore, the rinse liquid and the recovered liquid trapped in the cup 80 flow through the piping 91 and the piping 94a and flow to the recovered-liquid storage tank 210.

Thereafter, the rinse liquid supplying portion 40 stops the supply of the rinse liquid, and the rear surface processing liquid supplying portion 50 stops the supply of the recovered liquid. At this time, the substrate holding portion 20 may dry the substrate W by increasing the rotation speed of the substrate W. Thereafter, the substrate holding portion 20 stops the rotation of the substrate W, and the substrate W is carried out from the chamber 11.

According to the present preferred embodiment, the front surface Wa of the substrate W is alternately processed with the first chemical liquid, the second chemical liquid, and the rinse liquid as described above. According to the present preferred embodiment, in the period in which the rinse liquid is supplied to the front surface Wa of the substrate W, the recovered liquid is supplied to the rear surface Wb of the substrate W. Therefore, the substrate processing apparatus 100 according to the present preferred embodiment can reduce the use amount of a new processing liquid.

It is noted that, in the above description with reference to FIGS. 10A to 11C, in the period in which the rinse liquid is supplied to the front surface Wa of the substrate W after the second chemical liquid is supplied thereto, the rinse liquid is recovered as the recovered liquid after a predetermined time has elapsed, but the present preferred embodiment is not limited thereto. In the period in which the rinse liquid is supplied to the front surface Wa of the substrate W after the first chemical liquid is supplied thereto, the rinse liquid may be recovered as the recovered liquid after the predetermined time elapses.

Also, in the above description with reference to FIGS. 10A to 11C, in the period in which the rinse liquid is supplied to the front surface Wa of the substrate W after the second chemical liquid is supplied thereto, the recovered liquid is supplied to the rear surface Wb of the substrate W after a predetermined time has elapsed, but the present preferred embodiment is not limited thereto. In the period in which the rinse liquid is supplied to the front surface Wa of the substrate W after the first chemical liquid is supplied thereto, the recovered liquid may be supplied to the rear surface Wb of the substrate W after a predetermined time elapses.

Also, in the substrate processing apparatus 100 shown in FIGS. 2 and 5A to 11C, all of the liquids scattering from the rotating substrate W are trapped in the same cup 80, but the present preferred embodiment is not limited thereto. A plurality of types of cups 80 may be provided.

Also, in the substrate processing apparatus 100 shown in FIGS. 1 to 11C, the substrate holding portion 20 increases the rotation speed of the substrate W to dry the substrate W, but the present preferred embodiment is not limited thereto. The substrate W may be dried by supplying a gas. Also, after the substrate W is subjected to the rinse processing, a highly volatile processing liquid may be supplied to the substrate W to dry the substrate W.

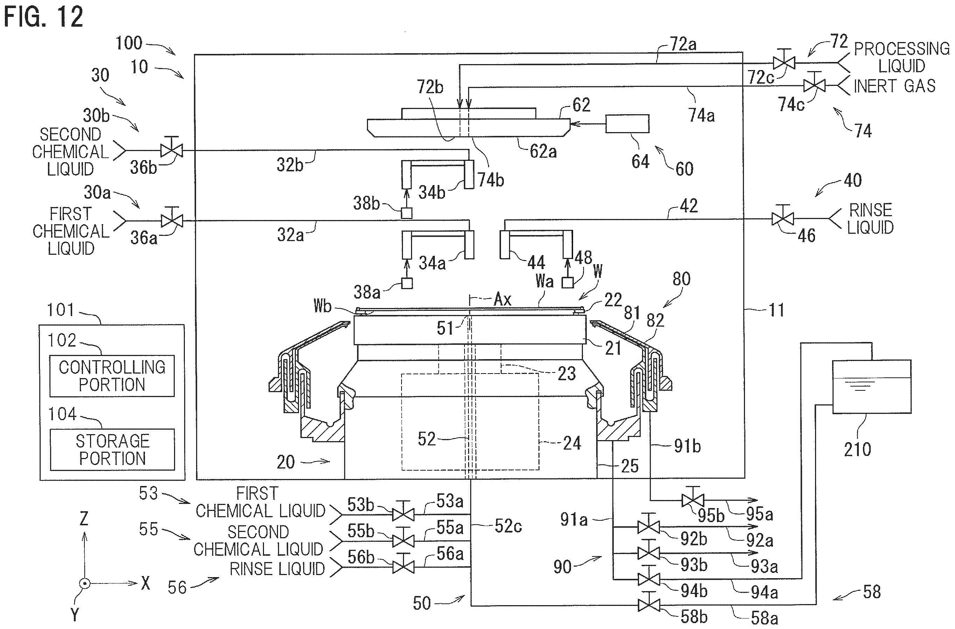

Next, the substrate processing apparatus 100 according to the present preferred embodiment will be described with reference to FIGS. 1 to 12. FIG. 12 is a schematic diagram of the substrate processing apparatus 100 according to the present preferred embodiment. The substrate processing apparatus 100 in FIG. 12 has the same configuration as the substrate processing apparatus 100 shown in FIG. 9 except that the cup 80 includes a first cup 81 and a second cup 82, and the substrate processing apparatus 100 further includes a shielding member 60, a processing liquid supplying portion 72, and an inert gas supplying portion 74, and redundant description is omitted for the purpose of avoiding the lengthy description.

As shown in FIG. 12, the substrate processing apparatus 100 further includes the shielding member 60, the processing liquid supplying portion 72, and the inert gas supplying portion 74. The shielding member 60 is positioned above the front surface Wa of the substrate W. The shielding member 60 is movable in the vertical direction with respect to the front surface Wa of the substrate W. The shielding member 60 shields the front surface Wa of the substrate W when moving close to the front surface Wa of the substrate W. The shielding member 60 supplies the processing liquid and an inert gas to the front surface Wa of the substrate W.

The shielding member 60 is configured to be movable with respect to the substrate W. The shielding member 60 further includes a shielding plate 62 and a moving portion 64. The shielding plate 62 has a plate shape expanding in a horizontal direction (XY plane). The shielding plate 62 is positioned above the front surface Wa of the substrate W held by the chuck member 22. A lower surface 62a of the shielding plate 62 faces the front surface Wa of the substrate W held by the chuck member 22. The lower surface 62a has, for example, a circular shape. A diameter of the lower surface 62a may be equal to or larger than a diameter of the substrate W.

The moving portion 64 elevates and lowers the shielding plate 62 in the vertical direction. For example, the moving portion 64 includes a ball screw mechanism and an electric motor that applies a driving force to the ball screw mechanism.

The moving portion 64 elevates and lowers the shielding plate 62 between a retreat position and a shielding position. The shielding position is a position lower than the retreat position. Specifically, as compared to the retreat position, the shielding position is a position closer to the substrate W held by the chuck member 22. In FIG. 12, the shielding plate 62 is positioned at the retreat position.

When the shielding plate 62 moves from the retreat position to the shielding position, a processing space is formed by the shielding plate 62 at the shielding position and the cup 80 at the upper position. The processing space is a space substantially shielded from the external atmosphere. That is, the processing space is a local space formed inside the chamber 11. The processing space is substantially shielded from the atmosphere inside the chamber 11.

The processing liquid supplying portion 72 supplies the processing liquid to the front surface Wa of the substrate W. Here, the processing liquid is suitably used for drying the rinse liquid. The processing liquid is preferably a low-surface-tension liquid having the surface tension lower than that of the rinse liquid. In this case, the substrate W is not dried immediately after the rinse liquid on the substrate W is completely spun off, but the substrate W is dried by spinning off the processing liquid on the substrate W after the rinse liquid on the substrate W is replaced with the processing liquid. Therefore, when the processing liquid is the low-surface-tension liquid, it is possible to decrease the surface tension acting on the substrate W when the substrate W is dried.

Examples of organic solvents that function as the processing liquid include a liquid, etc., containing at least one of IPA (isopropyl alcohol), HFE (hydrofluoroether), methanol, ethanol, acetone, PGEE (propylene glycol monoethyl ether), and trans-1,2-dichloroethylene. It is noted that, the processing liquid does not have to be a single component, and may be a liquid mixed with other components. For example, the processing liquid may be a mixed liquid of IPA and DIW or a mixed liquid of IPA and HFE.

The processing liquid supplying portion 72 includes a piping 72a, a nozzle 72b, and a valve 72c. The nozzle 72b is attached to the shielding plate 62. The processing liquid is supplied from a supply source to the piping 72a. The valve 72c opens and closes a flow channel in the piping 72a. The nozzle 72b discharges the processing liquid to the front surface Wa of the substrate W.

The valve 72c adjusts an opening degree of the piping 72a to adjust a flow rate of the processing liquid supplied to the piping 72a. Specifically, the valve 72c includes a valve body (not shown) with a valve seat provided in an interior, a valve element which opens/closes the valve seat, and an actuator (not shown) which moves the valve element between an open position and a closed position.

The inert gas supplying portion 74 supplies an inert gas to the front surface Wa of the substrate W. The inert gas does not substantially change the characteristics of the front surface Wa of the substrate W even when the inert gas is supplied to the front surface Wa of the substrate W. Typically, the inert gas is a nitrogen gas. It is noted that, the inert gas may be a rare gas.

The inert gas supplying portion 74 supplies an inert gas to the front surface Wa of the substrate W. The inert gas supplying portion 74 includes a piping 74a, a nozzle 74b, and a valve 74c. The nozzle 74b is attached to the shielding plate 62. The inert gas is supplied from a supply source to the piping 74a. The valve 74c opens and closes a flow channel in the piping 74a. The nozzle 74b discharges the inert gas to the front surface Wa of the substrate W.

The valve 74c adjusts an opening degree of the piping 74a to adjust a flow rate of the inert gas supplied to the piping 74a. Specifically, the valve 74c includes a valve body (not shown) with a valve seat provided in an interior, a valve element which opens/closes the valve seat, and an actuator (not shown) which moves the valve element between an open position and a closed position.

The nozzle 72b and the nozzle 74b are installed in the shielding plate 62. The discharge ports of the nozzle 72b and the nozzle 74b are open to the lower surface 62a of the shielding plate 62. The discharge ports of the nozzle 72b and the nozzle 74b may be positioned to face the central portion of the substrate W held by the chuck member 22. The nozzle 72b discharges the processing liquid toward the front surface Wa of the substrate W. The nozzle 74b discharges the inert gas toward the front surface Wa of the substrate W.

The cup 80 includes the first cup 81 and the second cup 82. The second cup 82 is positioned on an outer side in a radial direction of the substrate W with respect to the first cup 81. Both the first cup 81 and the second cup 82 are elevated and lowered along the vertical direction. The first cup 81 and the second cup 82 are elevated to an upper position that is positioned laterally to the substrate W. Also, the first cup 81 and the second cup 82 are lowered to a lower position that is positioned obliquely below the substrate W. The first cup 81 and the second cup 82 trap a liquid scattered from the substrate W.

It is noted that, the second cup 82 is positioned above the first cup 81 such as to overlap the first cup 81. Therefore, in a case where the first cup 81 is lowered, the second cup 82 can be lowered to a position where the first cup 81 is lowered.

The drain mechanism 90 discharges the chemical liquid, the rinse liquid, and the processing liquid trapped in the cup 80 to the outside of the chamber 11. The drain mechanism 90 includes a piping 91a to discharge the processing liquid trapped in the first cup 81 and a piping 91b to discharge the processing liquid trapped in the second cup 82. One end of the piping 91a is connected to a bottom portion of the first cup 81. One end of the piping 91b is connected to a bottom portion of the second cup 82.

The drain mechanism 90 further includes a piping 95a and a valve 95b in addition to the piping 92a, the valve 92b, the piping 93a, the valve 93b, the piping 94a and the valve 94b. The pipings 92a, 93a, and 94a are connected to the piping 91a. The piping 95a is connected to the piping 91b. The valve 95b has a configuration similar to those of the valves 92b, 93b, and 94b.

For example, the first cup 81 is positioned vertically above and to the lateral side of the substrate W over a period in which the first chemical liquid supplying portion 30a supplies the first chemical liquid to the substrate W. At this time, the second cup 82 is also positioned on the upper side similarly to the first cup 81.

Also, the first cup 81 is positioned laterally to the substrate W over a period in which the rinse liquid supplying portion 40 supplies the rinse liquid to the substrate W. Thereafter, the first cup 81 is positioned laterally to the substrate W over a period in which the second chemical liquid supplying portion 30b and the rinse liquid supplying portion 40 supply the second chemical liquid and the rinse liquid to the substrate W, respectively.

In this case, the first cup 81 traps the first chemical liquid, the rinse liquid, the second chemical liquid, and the rinse liquid scattering in accompaniment with the rotation of the substrate W. Thereafter, when the period in which the rinse liquid supplying portion 40 supplies the rinse liquid to the substrate W ends, the first cup 81 is lowered vertically downward from the lateral side of the substrate W. In this case, the second cup 82 is positioned laterally to the substrate W.

Thereafter, the second cup 82 is positioned laterally to the substrate W over a period in which the shielding member 60 supplies the processing liquid to the substrate W. Thereafter, the second cup 82 is positioned laterally to the substrate W over a period in which the shielding member 60 supplies the inert gas to the substrate W. Thereafter, when the period in which the shielding member 60 supplies the inert gas to the substrate W ends, the second cup 82 is lowered vertically downward from the lateral side of the substrate W.

The substrate processing apparatus 100 of the present preferred embodiment processes the front surface Wa of the substrate W alternately with the first chemical liquid, the second chemical liquid, and the rinse liquid. According to the present preferred embodiment, in at least a part of the period in which the rinse liquid is supplied to the front surface Wa of the substrate W, the recovered liquid is supplied to the rear surface Wb of the substrate W. Therefore, the substrate processing apparatus 100 according to the present preferred embodiment can reduce the use amount of a new processing liquid.

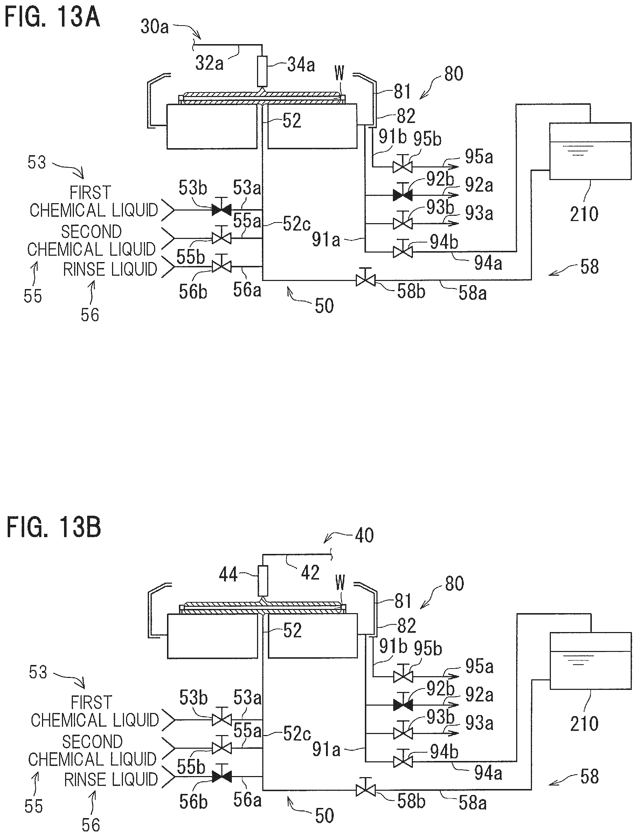

Next, the substrate processing apparatus 100 according to the present preferred embodiment will be described with reference to FIGS. 1 to 16B. FIGS. 13A to 16B are schematic diagrams showing a flow of the substrate processing apparatus 100 according to the present preferred embodiment. FIGS. 13A to 16B are similar to FIGS. 10A to 11C except that the cup 80 includes the first cup 81 and the second cup 82, and the processing liquid and the inert gas are supplied from the shielding member 60 to the front surface Wa of the substrate W, and redundant description is omitted in order to avoid the lengthy description.

As shown in FIG. 13A, the first chemical liquid is supplied to the front surface Wa and the rear surface Wb of the substrate W, and the front surface Wa and the rear surface Wb of the substrate W are processed with the first chemical liquid. The first chemical liquid supplying portion 30a supplies the first chemical liquid to the front surface Wa of the rotating substrate W. The rear surface processing liquid supplying portion 50 supplies the first chemical liquid to the rear surface Wb of the rotating substrate W.

Here, both the first cup 81 and the second cup 82 are positioned at the upper position. Therefore, the first cup 81 faces the side portion of the substrate W, and the first cup 81 traps the first chemical liquid scattering in accompaniment with the rotation of the substrate W.

In the drain mechanism 90, the valve 92b is opened while the valves 93b, 94b, and 95b are closed. Therefore, the first chemical liquid trapped in the first cup 81 flows and is discharged through the piping 91a and the piping 92a.

As shown in FIG. 13B, the rinse liquid is supplied to the front surface Wa and the rear surface Wb of the substrate W, and the front surface Wa and the rear surface Wb of the substrate W are processed with the rinse liquid. The rinse liquid supplying portion 40 supplies the rinse liquid to the front surface Wa of the rotating substrate W. The rear surface processing liquid supplying portion 50 supplies the rinse liquid to the rear surface Wb of the rotating substrate W. The first cup 81 traps the rinse liquid scattering in accompaniment with the rotation of the substrate W.

In the drain mechanism 90, the valve 92b is opened, and the valves 93b, 94b, and 95b remain closed. Therefore, the rinse liquid trapped in the first cup 81 flows and is discharged through the piping 91a and the piping 92a.

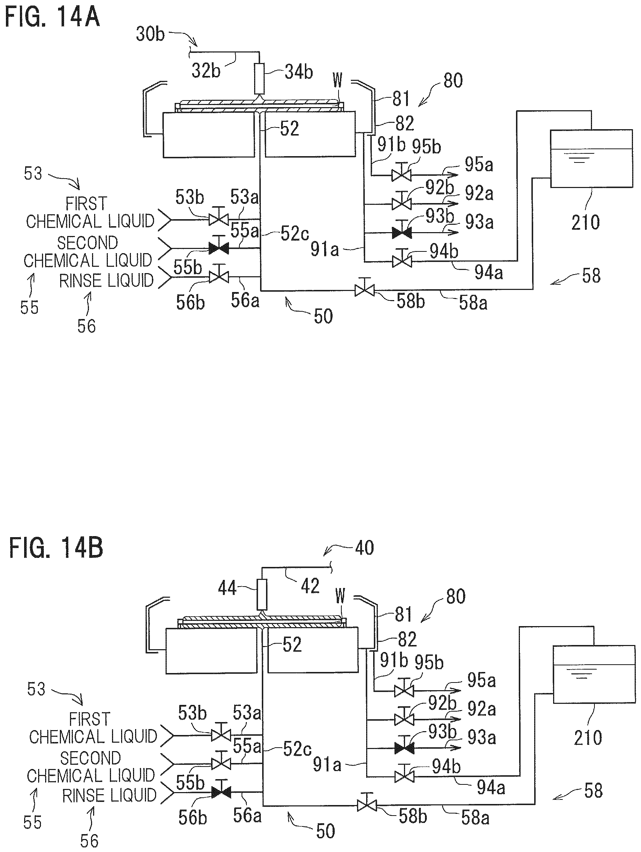

As shown in FIG. 14A, the second chemical liquid is supplied to the front surface Wa and the rear surface Wb of the substrate W, and the front surface Wa and the rear surface Wb of the substrate W are processed with the second chemical liquid. The second chemical liquid supplying portion 30b supplies the second chemical liquid to the front surface Wa of the rotating substrate W. The rear surface processing liquid supplying portion 50 supplies the second chemical liquid to the rear surface Wb of the rotating substrate W. Here, the first cup 81 traps the second chemical liquid scattering in accompaniment with the rotation of the substrate W.

In the drain mechanism 90, the valve 93b is opened while the valves 92b, 94b, and 95b are closed. Therefore, the second chemical liquid trapped in the first cup 81 flows and is discharged through the piping 91a and the piping 93a.

As shown in FIG. 14B, the rinse liquid is supplied to the front surface Wa and the rear surface Wb of the substrate W, and the front surface Wa and the rear surface Wb of the substrate W are processed with the rinse liquid. The rinse liquid supplying portion 40 supplies the rinse liquid to the front surface Wa of the rotating substrate W. The rear surface processing liquid supplying portion 50 supplies the rinse liquid to the rear surface Wb of the rotating substrate W. Here, the first cup 81 traps the rinse liquid scattering in accompaniment with the rotation of the substrate W.

In the drain mechanism 90, the valve 93b is opened, and the valves 92b, 94b, and 95b remain closed. Therefore, the rinse liquid trapped in the first cup 81 flows and is discharged through the piping 91a and the piping 93a.

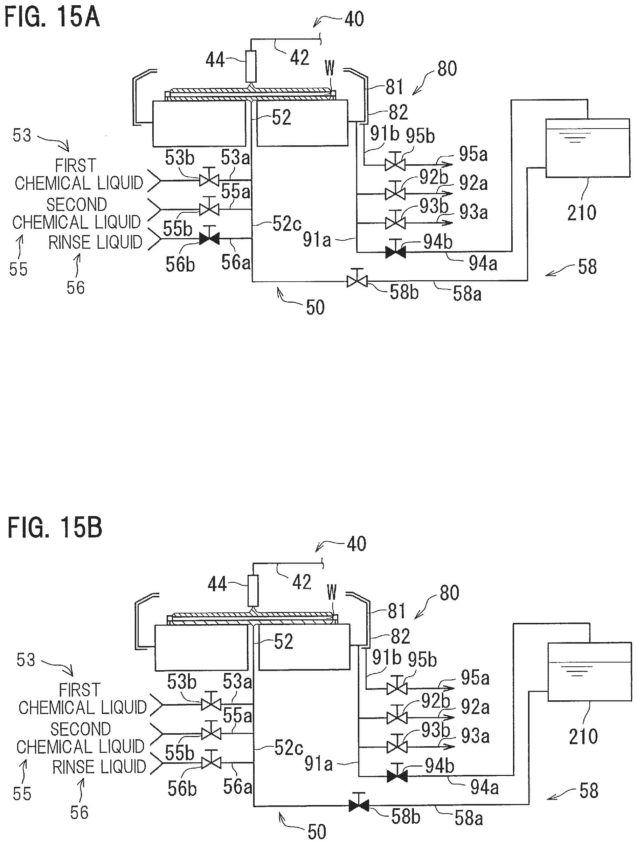

As shown in FIG. 15A, the rinse liquid is supplied to the front surface Wa and the rear surface Wb of the substrate W, and the front surface Wa and the rear surface Wb of the substrate W are processed with the rinse liquid. The rinse liquid supplying portion 40 continues supplying the rinse liquid to the front surface Wa of the rotating substrate W. The rear surface processing liquid supplying portion 50 continues supplying the rinse liquid to the rear surface Wb of the substrate W. In this case, the cup 80 traps the rinse liquid scattering in accompaniment with the rotation of the substrate W.

In the drain mechanism 90, the valve 94b is opened, and the valves 92b, 93b, and 95b are closed. Therefore, the rinse liquid trapped in the cup 80 flows through the piping 91a and the piping 94a and flows to the recovered-liquid storage tank 210.

As shown in FIG. 15B, the rinse liquid is supplied to the front surface Wa of the substrate W so that the front surface Wa of the substrate W is processed with the rinse liquid, and the recovered liquid is supplied to the rear surface Wb of the substrate W so that the rear surface Wb of the substrate W is processed with the recovered liquid. The rinse liquid supplying portion 40 supplies the rinse liquid to the front surface Wa of the rotating substrate W. The rear surface processing liquid supplying portion 50 supplies the recovered liquid to the rear surface Wb of the substrate W.

In the drain mechanism 90, the valve 94b is opened, and the valves 92b and 93b are closed. Therefore, the rinse liquid and the recovered liquid trapped in the first cup 81 flow through the piping 91a and the piping 94a and flow to the recovered-liquid storage tank 210.

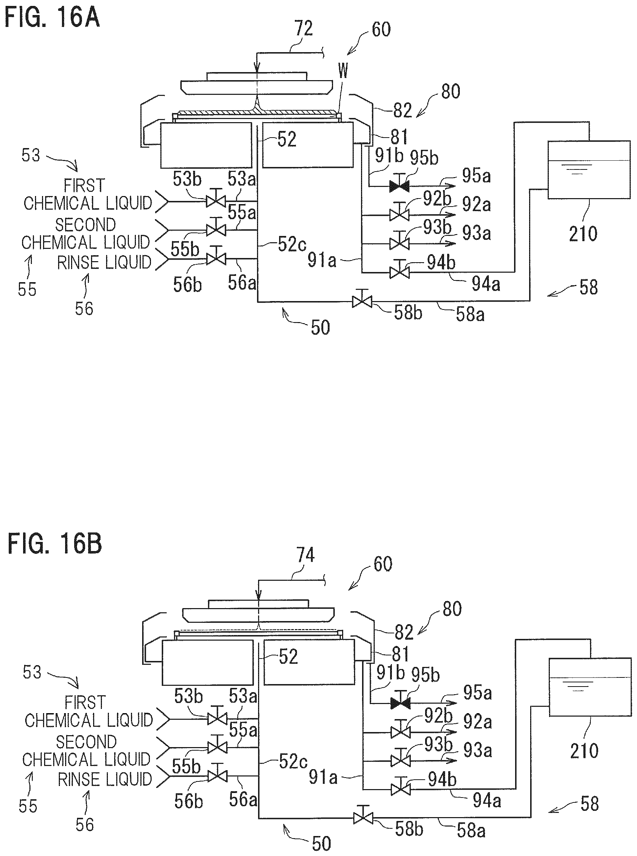

As shown in FIG. 16A, the processing liquid is supplied to the front surface Wa of the substrate W, and the front surface Wa of the substrate W is processed with the processing liquid. The shielding member 60 supplies the processing liquid to the front surface Wa of the rotating substrate W. The rear surface processing liquid supplying portion 50 stops the supply of the processing liquid to the rear surface Wb of the substrate W.

Here, the first cup 81 moves from the upper position to the lower position, and the second cup 82 is positioned at the upper position. Therefore, the second cup 82 faces the side portion of the substrate W. The second cup 82 traps the processing liquid scattering in accompaniment with the rotation of the substrate W.

In the drain mechanism 90, the valve 95b is opened, and the valves 92b, 93b, and 94b are closed. Therefore, the processing liquid trapped in the second cup 82 flows and is discharged through the piping 91b and the piping 95a.

As shown in FIG. 16B, the inert gas is supplied to the front surface Wa of the substrate W to blow off the processing liquid on the front surface Wa of the substrate W. The shielding member 60 supplies the inert gas to the front surface Wa of the rotating substrate W. The rear surface processing liquid supplying portion 50 remains stopping the supply of the processing liquid to the rear surface Wb of the substrate W. At this time, the substrate holding portion 20 may increase the rotation speed of the substrate W.

Here, the second cup 82 remains positioned at the upper position. The second cup 82 traps the processing liquid scattering in accompaniment with the rotation of the substrate W.

In the drain mechanism 90, the valve 95b is opened, and the valves 92b, 93b, and 94b are closed. Therefore, the processing liquid trapped in the second cup 82 flows and is discharged through the piping 91b and the piping 95a.

Thereafter, the shielding member 60 stops the supply of the inert gas, and the substrate holding portion 20 stops the rotation of the substrate W. In this manner, the substrate W is dried. Thereafter, the substrate W is carried out from the chamber 11.

The substrate processing apparatus 100 of the present preferred embodiment processes the front surface Wa of the substrate W alternately with the first chemical liquid, the second chemical liquid, and the rinse liquid. According to the present preferred embodiment, in at least a part of the period in which the rinse liquid is supplied to the front surface Wa of the substrate W, the recovered liquid is supplied to the rear surface Wb of the substrate W. Therefore, the substrate processing apparatus 100 according to the present preferred embodiment can reduce the use amount of a new processing liquid.

It is noted that, in FIG. 16A, the valve 94b is closed when the shielding member 60 supplies the processing liquid to the front surface Wa of the substrate W, however, when the shielding member 60 supplies the processing liquid to the front surface Wa of the substrate W, the valve 94b in which the rinse liquid and the recovered liquid trapped in the first cup 81 flow may remain open. Consequently, even when the shielding member 60 supplies the processing liquid to the front surface Wa of the substrate W, the recovered-liquid storage tank 210 can recover the rinse liquid and the recovered liquid trapped in the first cup 81. It is noted that, the valve 94b may be opened for a predetermined time from the start of the period in which the shielding member 60 supplies the processing liquid to the front surface Wa of the substrate W, and the valve 94b may be closed after the predetermined time elapses.

It is noted that, in the substrate processing apparatus 100 shown in FIGS. 12 to 16B, the cup 80 has the first cup 81 and the second cup 82, but the present preferred embodiment is not limited thereto. The cup 80 may include three or more cups.

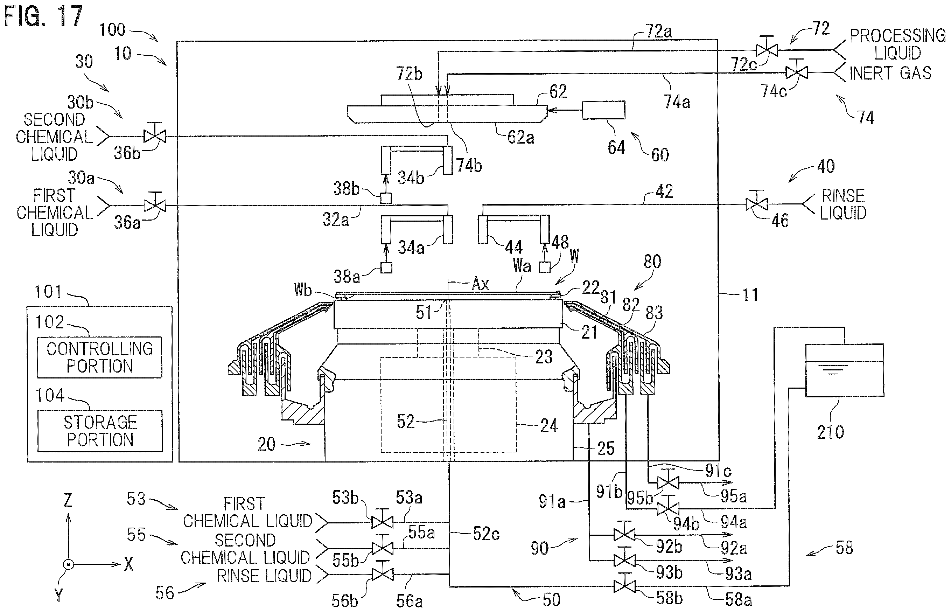

Next, the substrate processing apparatus 100 according to the present preferred embodiment will be described with reference to FIGS. 1 to 17. FIG. 17 is a schematic diagram of the substrate processing apparatus 100 according to the present preferred embodiment. The substrate processing unit 10 in FIG. 17 has the same configuration as the substrate processing apparatus 100 shown in FIG. 12 except that the cup 80 further includes a third cup 83 in addition to the first cup 81 and the second cup 82, and redundant description is omitted for the purpose of avoiding the lengthy description.

As shown in FIG. 17, the cup 80 includes the first cup 81, the second cup 82, and the third cup 83. The third cup 83 is positioned on an outer side in a radial direction of the substrate W with respect to the second cup 82. The first cup 81 to the third cup 83 are individually elevated and lowered along the vertical direction. The first cup 81 to the third cup 83 are elevated to an upper position that is positioned laterally to the substrate W. Also, the first cup 81 to the third cup 83 are lowered to a lower position that is positioned obliquely below the substrate W. The first cup 81 to the third cup 83 trap a liquid scattered from the substrate W.

It is noted that, the third cup 83 is positioned above the second cup 82 such as to overlap the second cup 82. Therefore, in a case where the second cup 82 is lowered, the third cup 83 can be lowered to a position where the second cup 82 is lowered.

The drain mechanism 90 discharges the chemical liquid, the rinse liquid, and the processing liquid trapped in the cup 80 to the outside of the chamber 11. The drain mechanism 90 includes the piping 91a to discharge the processing liquid trapped in the first cup 81, the piping 91b to discharge the processing liquid trapped in the second cup 82, and a piping 91c to discharge the processing liquid trapped in the third cup 83. One end of the piping 91a is connected to a bottom portion of the first cup 81. One end of the piping 91b is connected to a bottom portion of the second cup 82. One end of the piping 91c is connected to the third cup 83.

In the drain mechanism 90, the pipings 92a and 93a are connected to the piping 91a. The piping 94a is connected to the piping 91b. The piping 95a is connected to the piping 91c.

For example, the first cup 81 is positioned vertically above and to the lateral side of the substrate W over a period in which the first chemical liquid supplying portion 30a supplies the first chemical liquid to the substrate W. At this time, the second cup 82 is also positioned on the upper side similarly to the first cup 81.

Also, the first cup 81 is positioned laterally to the substrate W over a period in which the rinse liquid supplying portion 40 supplies the rinse liquid to the substrate W. Thereafter, the first cup 81 is positioned laterally to the substrate W over a period in which the second chemical liquid supplying portion 30b and the rinse liquid supplying portion 40 supply the second chemical liquid and the rinse liquid to the substrate W, respectively.

In this case, the first cup 81 traps the first chemical liquid, the rinse liquid, the second chemical liquid, and the rinse liquid scattering in accompaniment with the rotation of the substrate W. Thereafter, when the period in which the rinse liquid supplying portion 40 supplies the rinse liquid to the substrate W ends, the first cup 81 is lowered vertically downward from the lateral side of the substrate W. In this case, the second cup 82 is positioned laterally to the substrate W.

Thereafter, the second cup 82 is positioned on the lateral side of the substrate W while the rinse liquid and the recovered liquid supplied to the substrate W are caused to flow into the recovered-liquid storage tank 210.

Thereafter, when the shielding member 60 shields the front surface Wa of the substrate W and starts supplying the processing liquid to the substrate W, the second cup 82 is lowered vertically downward from the lateral side of the substrate W, and the third cup 83 is positioned laterally to the substrate W in a period in which the shielding member 60 supplies the processing liquid to the substrate W. Thereafter, the third cup 83 is positioned laterally to the substrate W over a period in which the shielding member 60 supplies the inert gas to the substrate W. The third cup 83 traps the processing liquid scattering in accompaniment with the rotation of the substrate W. Thereafter, when the period in which the shielding member 60 supplies the inert gas to the substrate W ends, the third cup 83 is lowered vertically downward from the lateral side of the substrate W.

The substrate processing apparatus 100 of the present preferred embodiment processes the front surface Wa of the substrate W alternately with the first chemical liquid, the second chemical liquid, and the rinse liquid. According to the present preferred embodiment, in at least a part of the period in which the rinse liquid is supplied to the front surface Wa of the substrate W, the recovered liquid is supplied to the rear surface Wb of the substrate W. Therefore, the substrate processing apparatus 100 according to the present preferred embodiment can reduce the use amount of a new processing liquid.

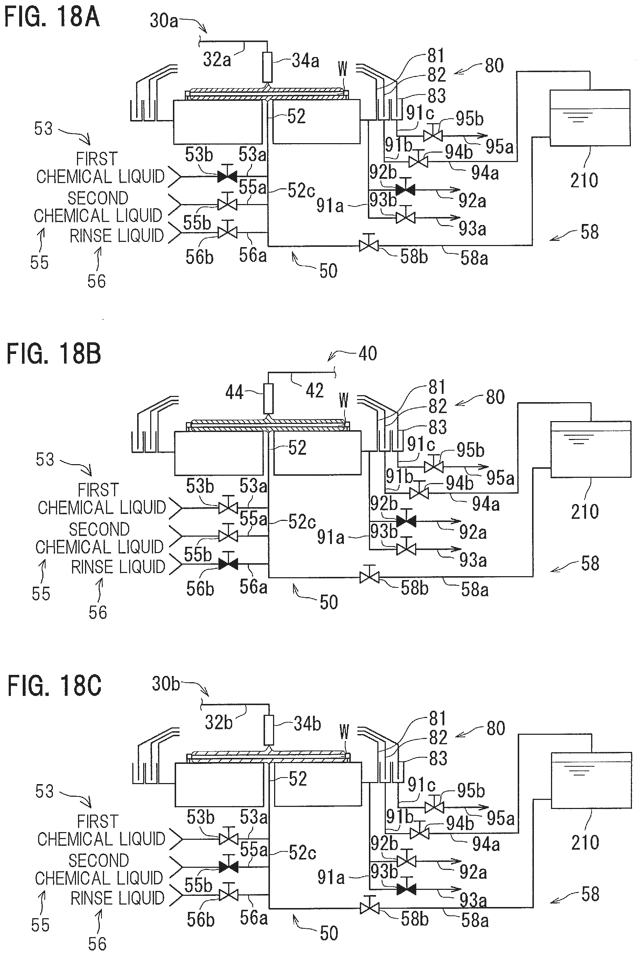

Next, the substrate processing apparatus 100 according to the present preferred embodiment will be described with reference to FIGS. 1 to 20. FIGS. 18A to 20 are schematic diagrams showing a flow of the substrate processing apparatus 100 according to the present preferred embodiment. The flow in FIGS. 18A to 20 are similar to the flow of the substrate processing apparatus 100 described above with reference to FIGS. 13A to 16B except that the cup 80 further includes the third cup 83 in addition to the first cup 81 and the second cup 82, and redundant description is omitted in order to avoid the lengthy description.

As shown in FIG. 18A, the first chemical liquid is supplied to the front surface Wa and the rear surface Wb of the substrate W, and the front surface Wa and the rear surface Wb of the substrate W are processed with the first chemical liquid. The first chemical liquid supplying portion 30a supplies the first chemical liquid to the front surface Wa of the rotating substrate W. The rear surface processing liquid supplying portion 50 supplies the first chemical liquid to the rear surface Wb of the rotating substrate W.

Here, the first cup 81 to the third cup 83 are all positioned at the upper position. Therefore, the first cup 81 faces the side portion of the substrate W. The first cup 81 traps the first chemical liquid scattering in accompaniment with the rotation of the substrate W.

In the drain mechanism 90, the valve 92b is opened while the valves 93b, 94b, and 95b are closed. Therefore, the first chemical liquid trapped in the first cup 81 flows and is discharged through the piping 91a and the piping 92a.

As illustrated in FIG. 18B, the rinse liquid is supplied to the front surface Wa and the rear surface Wb of the substrate W, and the front surface Wa and the rear surface Wb of the substrate W are processed with the rinse liquid. The rinse liquid supplying portion 40 supplies the rinse liquid to the front surface Wa of the rotating substrate W. The rear surface processing liquid supplying portion 50 supplies the rinse liquid to the rear surface Wb of the rotating substrate W. Here, the first cup 81 traps the rinse liquid scattering in accompaniment with the rotation of the substrate W.

In the drain mechanism 90, the valve 92b is opened, and the valves 93b, 94b, and 95b remain closed. Therefore, the rinse liquid trapped in the first cup 81 flows and is discharged through the piping 91a and the piping 92a.

As shown in FIG. 18C, the second chemical liquid is supplied to the front surface Wa and the rear surface Wb of the substrate W, and the front surface Wa and the rear surface Wb of the substrate W are processed with the second chemical liquid. The second chemical liquid supplying portion 30b supplies the second chemical liquid to the front surface Wa of the rotating substrate W. The rear surface processing liquid supplying portion 50 supplies the second chemical liquid to the rear surface Wb of the rotating substrate W. Here, the first cup 81 traps the second chemical liquid scattering in accompaniment with the rotation of the substrate W.

In the drain mechanism 90, the valve 93b is opened while the valves 92b, 94b, and 95b are closed. Therefore, the second chemical liquid trapped in the first cup 81 flows and is discharged through the piping 91a and the piping 93a.

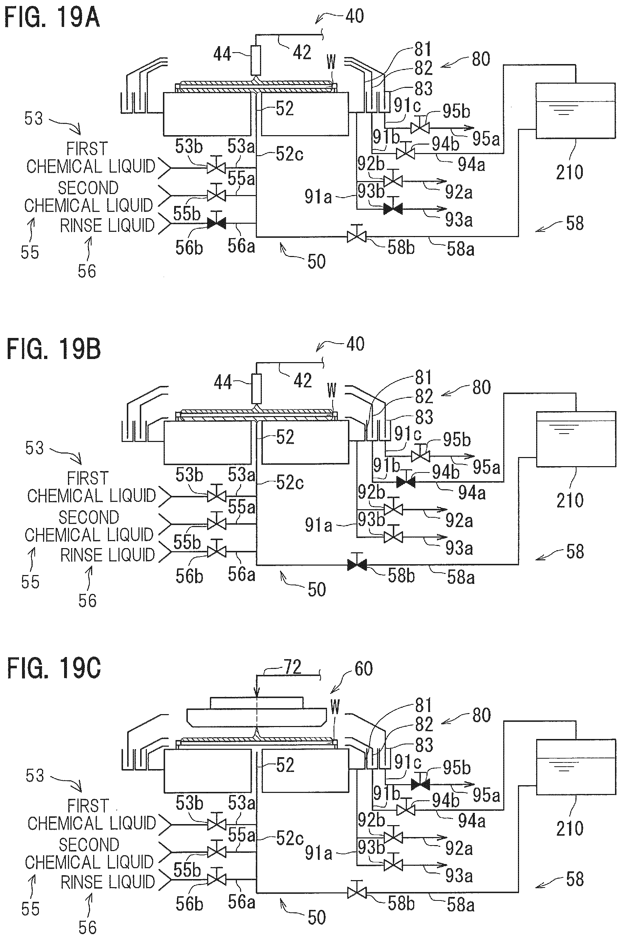

As shown in FIG. 19A, the rinse liquid is supplied to the front surface Wa and the rear surface Wb of the substrate W, and the front surface Wa and the rear surface Wb of the substrate W are processed with the rinse liquid. The rinse liquid supplying portion 40 supplies the rinse liquid to the front surface Wa of the rotating substrate W. The rear surface processing liquid supplying portion 50 supplies the rinse liquid to the rear surface Wb of the rotating substrate W. Here, the first cup 81 traps the rinse liquid scattering in accompaniment with the rotation of the substrate W.

In the drain mechanism 90, the valve 93b is opened, and the valves 92b, 94b, and 95b remain closed. Therefore, the rinse liquid trapped in the first cup 81 flows and is discharged through the piping 91a and the piping 93a.

As shown in FIG. 19B, the rinse liquid is supplied to the front surface Wa of the substrate W so that the front surface Wa of the substrate W is processed with the rinse liquid, and the recovered liquid is supplied to the rear surface Wb of the substrate W so that the rear surface Wb of the substrate W is processed with the recovered liquid. The rinse liquid supplying portion 40 continues supplying the rinse liquid to the front surface Wa of the rotating substrate W. The rear surface processing liquid supplying portion 50 supplies the recovered liquid to the rear surface Wb of the substrate W.

Here, the first cup 81 moves from the upper position to the lower position, and the second cup 82 and the third cup 83 are both positioned at the upper position. Therefore, the second cup 82 faces the side portion of the substrate W. The second cup 82 traps the rinse liquid and the recovered liquid scattering in accompaniment with the rotation of the substrate W.

In the drain mechanism 90, the valve 94b is opened, and the valves 92b, 93b, and 95b are closed. Therefore, the rinse liquid and the recovered liquid trapped in the second cup 82 flow through the piping 91b and the piping 94a and are recovered in the recovered-liquid storage tank 210.

As shown in FIG. 19C, the processing liquid is supplied to the front surface Wa of the substrate W, and the front surface Wa of the substrate W is processed with the processing liquid. The shielding member 60 supplies the processing liquid to the front surface Wa of the rotating substrate W. The rear surface processing liquid supplying portion 50 stops the supply of the processing liquid to the rear surface Wb of the substrate W.

Here, the second cup 82 moves from the upper position to the lower position, and third cup 83 is positioned at the upper position. Therefore, the third cup 83 faces the side portion of the substrate W. The third cup 83 traps the processing liquid scattering in accompaniment with the rotation of the substrate W.

In the drain mechanism 90, the valve 95b is opened, and the valves 92b, 93b, and 94b are closed. Therefore, the processing liquid trapped in the third cup 83 flows and is discharged through the piping 91c and the piping 95a.

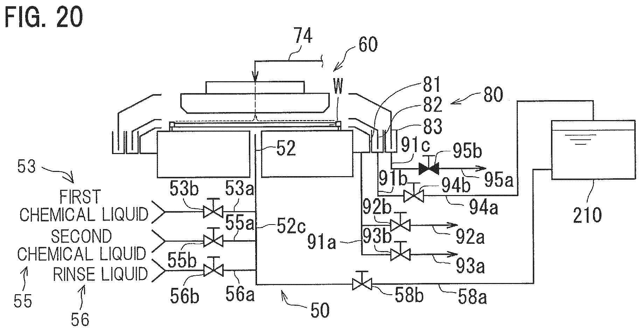

As shown in FIG. 20, the inert gas is supplied to the front surface Wa of the substrate W to blow off the processing liquid on the front surface Wa of the substrate W. The shielding member 60 supplies the inert gas to the front surface Wa of the rotating substrate W. The rear surface processing liquid supplying portion 50 remains stopping the supply of the processing liquid to the rear surface Wb of the substrate W. At this time, the substrate holding portion 20 may increase the rotation speed of the substrate W.

Here, the third cup 83 remains positioned at the upper position. The third cup 83 traps the processing liquid scattering in accompaniment with the rotation of the substrate W.

In the drain mechanism 90, the valve 95b is opened, and the valves 92b, 93b, and 94b remain closed. Therefore, the processing liquid trapped in the third cup 83 flows and is discharged through the piping 91c and the piping 95a.

Thereafter, the shielding member 60 stops the supply of the inert gas, and the substrate holding portion 20 stops the rotation of the substrate W. In this manner, the substrate W is dried. Thereafter, the substrate W is carried out from the chamber 11.

The substrate processing apparatus 100 of the present preferred embodiment processes the front surface Wa of the substrate W alternately with the first chemical liquid, the second chemical liquid, and the rinse liquid. According to the present preferred embodiment, in at least a part of the period in which the rinse liquid is supplied to the front surface Wa of the substrate W, the recovered liquid is supplied to the rear surface Wb of the substrate W. Therefore, the substrate processing apparatus 100 according to the present preferred embodiment can reduce the use amount of a new processing liquid.

The preferred embodiments of the present disclosure have been described above with reference to the drawings. However, the present disclosure is not limited to the preferred embodiments described above, and can be implemented in various modes within the range not departing from the gist thereof. Also, by appropriately combining the plurality of constituent elements disclosed in the preferred embodiment described above, it is possible to form various inventions. For example, some constituent elements may be deleted from all constituent elements shown in the preferred embodiment. Further, the constituent elements of different preferred embodiments may be appropriately combined. The drawings schematically show the respective constituent elements mainly in order to facilitate understanding, and the thickness, the length, the number, the interval, etc., of each constituent element shown in the figures may be different from the actual ones for convenience in creating the drawings. Also, the material, the shape, the size, etc., of each constituent element shown in the preferred embodiment described above are not particularly limited but just an example, and can be variously changed within the range substantially not departing from the effects of the present disclosure.

It is noted that, in the substrate processing apparatus 100 shown in FIGS. 2 and 5A to 20, the front surface Wa of the substrate W faces vertically upward, and the rear surface Wb of the substrate W faces vertically downward, but the present preferred embodiment is not limited thereto. The front surface Wa of the substrate W may face vertically downward, and the rear surface Wb of the substrate W may face vertically upward. In this case, the recovered liquid is supplied to the rear surface Wb of the substrate W facing vertically upward.

Also, in the substrate processing apparatus 100 illustrated in FIG. 1, the recovered-liquid storage tank 210 is disposed in the processing liquid cabinet 110, but the present preferred embodiment is not limited thereto. The recovered-liquid storage tank 210 may be disposed at a position different from the processing liquid cabinet 110. For example, the recovered-liquid storage tank 210 may be disposed in the processing liquid box 120. Alternatively, the recovered-liquid storage tank 210 may be disposed in the chamber 11.

Although the preferred embodiments of the present invention have been described in detail, these are merely specific examples used to clarify the technical contents of the present invention, and the present invention should not be construed as limited to these specific examples, and the scope of the present invention is limited only by the accompanying claims.

## Claims

1. A substrate processing apparatus (100) comprising:
a chamber (11) to accommodate a substrate (W) having a front surface (Wa) on which a device is provided and a rear surface (Wb) positioned on an opposite side to the front surface (Wa);
a substrate holding portion (20) to hold the substrate (W) in the chamber (11);
a chemical liquid supplying portion (30) to supply a chemical liquid to the front surface (Wa) of the substrate (W) held by the substrate holding portion (20);
a rinse liquid supplying portion (40) to supply a rinse liquid to the front surface (Wa) of the substrate (W) held by the substrate holding portion (20);
a cup (80) to trap the rinse liquid scattered from the substrate (W) held by the substrate holding portion (20);
a recovered-liquid storage tank (210) to store, as a recovered liquid, the rinse liquid recovered in the cup (80); and
a rear surface processing liquid supplying portion (50) to supply the recovered liquid stored in the recovered-liquid storage tank (210) to the rear surface (Wb) of the substrate (W) held by the substrate holding portion (20).

2. The substrate processing apparatus (100) according to claim 1, further comprising a piping (94a) which connects the cup (80) and the recovered-liquid storage tank (210) and into which the rinse liquid trapped in the cup (80) is to flow.

3. The substrate processing apparatus (100) according to claim 1 or 2, wherein the rear surface processing liquid supplying portion (50) is to supply the recovered liquid to the rear surface (Wb) of the substrate (W) in a period in which the rinse liquid supplying portion (40) supplies the rinse liquid to the front surface (Wa) of the substrate (W).

4. The substrate processing apparatus (100) according to any one of claims 1 to 3, wherein the rear surface processing liquid supplying portion (50) is to supply the rinse liquid to the rear surface (Wb) of the substrate (W) and then to supply the recovered liquid in a period in which the rinse liquid supplying portion (40) supplies the rinse liquid to the front surface (Wa) of the substrate (W).

5. The substrate processing apparatus (100) according to any one of claims 1 to 4, wherein, while the rinse liquid supplying portion (40) supplies the rinse liquid to the front surface (Wa) of the substrate (W), the recovered-liquid storage tank (210) is to recover, as a recovered liquid, the rinse liquid supplied to the substrate (W) and the rear surface processing liquid supplying portion (50) is to supply the recovered liquid to the rear surface (Wb) of the substrate (W).

6. The substrate processing apparatus (100) according to any one of claims 1 to 5, wherein the rear surface processing liquid supplying portion (50) is to supply the recovered liquid to the rear surface (Wb) of the substrate (W) both while the chemical liquid supplying portion (30) supplies the chemical liquid to the front surface (Wa) of the substrate (W) and while the rinse liquid supplying portion (40) supplies the rinse liquid to the front surface (Wa) of the substrate (W).

7. A substrate processing method comprising:
a step of holding, by a substrate holding portion (20), a substrate (W) having a front surface (Wa) on which a device is provided and a rear surface (Wb) positioned on an opposite side to the front surface (Wa);
a step of supplying a chemical liquid to the front surface (Wa) of the substrate (W) held by the substrate holding portion (20);
a step of supplying a rinse liquid to the front surface (Wa) of the substrate (W) held by the substrate holding portion (20) after the chemical liquid is supplied to the front surface (Wa) of the substrate (W);
a step of recovering, in a recovered-liquid storage tank (210), the rinse liquid supplied to the substrate (W) as a recovered liquid; and
a step of supplying the recovered liquid in the recovered-liquid storage tank (210) to the rear surface (Wb) of the substrate (W) held by the substrate holding portion (20) .

8. The substrate processing method according to claim 7, wherein the recovered liquid is supplied to the rear surface (Wb) of the substrate (W), in a period in which the rinse liquid is supplied to the front surface (Wa) of the substrate (W) .

9. The substrate processing method according to claim 7 or 8, wherein the rinse liquid is supplied to the rear surface (Wb) of the substrate (W) and then the recovered liquid is supplied in a period in which the rinse liquid is supplied to the front surface (Wa) of the substrate (W).

10. The substrate processing method according to any one of claims 7 to 9, wherein the rinse liquid supplied to the substrate (W) is recovered as a recovered liquid in the recovered-liquid storage tank (210), and the recovered liquid is supplied to the rear surface (Wb) of the substrate (W) while the rinse liquid is supplied to the front surface (Wa) of the substrate (W) .

11. The substrate processing method according to any one of claims 7 to 10, wherein the recovered liquid is supplied to the rear surface (Wb) of the substrate (W) both while the chemical liquid is supplied to the front surface (Wa) of the substrate (W) and while the rinse liquid is supplied to the front surface (Wa) of the substrate (W).
